# EUROPÄISCHE PATENTSCHRIFT

(11) **EP 1 613 969 B1**
(45) Veröffentlichungstag und Bekanntmachung des Hinweises auf die Patenterteilung: **29.07.2009**
(21) Anmeldenummer: 03720476.5
(22) Anmeldetag: 15.04.2003
(51) Int. Cl.: G02B 26/08, G01P 15/10, G01C 19/56, H03H 9/24, H03H 3/013, B81B 3/00

(54) **MIKROMECHANISCHES BAUELEMENT MIT EINSTELLBARER RESONANZFREQUENZ**
MICROMECHANICAL COMPONENT HAVING AN ADJUSTABLE RESONANCE FREQUENCY
COMPOSANT MICROMECANIQUE AYANT UNE FREQUENCE DE RESONANCE REGLABLE

(43) Veröffentlichungstag der Anmeldung: 11.01.2006
(73) Patentinhaber: Fraunhofer-Gesellschaft zur Förderung der angewandten Forschung e.V., 80686 München (DE)
(72) Erfinder: DRABE, Christian, 01099 Dresden (DE); WOLTER, Alexander, 01156 Dresden (DE); SCHENK, Harald, 01139 Dresden (DE)
(74) Vertreter: Schenk, Markus
(86) Internationale Anmeldenummer: PCT/EP2003/003943
(87) Internationale Veröffentlichungsnummer: WO 2004/092745

(56) Entgegenhaltungen:
- US-A- 4 750 364
- US-A- 5 126 812
- US-A- 5 144 184
- US-A- 5 605 598
- US-A1- 2002 105 393
- US-B1- 6 300 619

## Beschreibung

Die vorliegende Erfindung bezieht sich auf mikromechanische Bauelemente mit einem Schwingungssystem und insbesondere auf die Einstellung der Schwingungsfrequenz des Schwingungssystems.

Mikromechanische Bauelemente mit Schwingungssystemen kommen sowohl als mikromechanische Sensoren als auch als mikromechanische Aktuatoren zum Einsatz. Das aus Schwingungskörper und elastischer Aufhängung bestehende Schwingungssystem weist eine Eigen- bzw. Resonanzfrequenz auf. Bei vielen Anwendungen muß die Resonanzfrequenz des Schwingungssystems einer fest vorgegebenen Frequenz entsprechen, um unter Ausnutzung der Resonanzerhöhung im Fall eines Sensors beispielsweise eine ausreichende Empfindlichkeit und im Fall eines Aktuators beispielsweise eine ausreichende Schwingungsamplitude zu erzielen. Beispiele für solche mikromechanischen Bauelemente mit einem Schwingungssystem sind Taktgeber in Uhren oder ablenkende Spiegel, wie z.B. Scannerspiegel, die für die Datenprojektion verwendet werden. Bei den letztgenannten Scannerspiegeln müssen beispielsweise die Datenfrequenz bzw. die Modulationsfrequenz und die Schwingungsfrequenz in einem fest vorgegebenen Verhältnis stehen. Ein weiteres Beispiel für eine Anwendung, bei der eine Sollfrequenz vorgegeben ist, liegt vor, wenn ein Paar eines Sensors bzw. eines Aktuators, die im Prinzip baugleich sind, miteinander synchronisiert werden sollen.

Um die für die Schwingungsgeneration aufzuwendende Leistung gering zu halten, besitzen die Schwingungssysteme solcher Bauelemente im allgemeinen eine verhältnismäßig hohe Güte, mit der Konsequenz, daß die Resonanzkurve schmal ist und daß unter Beibehaltung der gewünschten Schwingungsamplitude nur ein sehr geringer Spielraum bei der Anregungsfrequenz besteht.

Die Ursachen für eine Abweichung der Resonanzfrequenz des Schwingungssystems eines mikromechanischen Bauelements von einer Sollresonanzfrequenz sind äußerst vielseitig und können grob in zwei Gruppen eingeteilt werden, nämlich solche, die trotz identischer und konstanter Umgebungsbedingungen zu einer konstanten Resonanzfrequenzabweichung bzw. einem Resonanzfrequenzoffset führen und beispielsweise durch Produktions- bzw. Herstellungsschwankungen/toleranzen bedingt sind, und solche, die zeitlichen Änderungen unterworfen sind und/oder beispielsweise durch Umgebungsbedingungsschwankungen hervorgerufen werden. Im folgenden wird für die konstante, beispielsweise herstellungsbedingte Abweichung der tatsächlichen Resonanzfrequenz eines mikromechanischen Bauelements von seiner Sollresonanzfrequenz der Begriff "Resonanzfrequenzabweichung" verwendet, während für die während des Betriebs bzw. der Lebensdauer zeitlichen Änderungen unterworfenen Frequenzabweichungen der Begriff "Resonanzfrequenzschwankung" verwendet wird.

Unter den Begriff Resonanzfrequenzabweichung fällt folglich beispielsweise auch das Nichtübereinstimmen der Resonanzfrequenz im Prinzip baugleicher Bauelemente, welche trotz identischer und konstanter Umgebungsbedingungen auftritt. Die Ursache hierfür sind Variationen frequenzbestimmender Materialparameter, wie z.B. elastischer Konstanten, der Dichte usw., und statistische bzw. systematische Abweichungen der Dimensionen von Feder und Masse bzw. dämpfend wirkenden Zwischenräumen aufgrund von Toleranzen in Justage, Strukturierung und Schichtgeneration bei der Herstellung der mikromechanischen Bauelemente.

Unter dem Begriff Resonanzfrequenzschwankung wird demgegenüber die Schwankung der Resonanzfrequenz des Schwingungssystems eines mikromechanischen Bauelements aufgrund von beispielsweise Umgebungsbedingungsschwankungen verstanden, wie z.B. Schwankungen des Drucks oder der Temperatur. Resonanzfrequenzschwankungen können aber auch durch unterschiedlich stark ausgeprägte Adsorption von unterschiedlichen Gasmolekülen, Feuchtigkeit und ähnlichem an dem Schwingungssystem oder durch zeitliche Veränderungen der Materialparameter hervorgerufen werden.

Die bisher bekannten Maßnahmen zur Einstellung der Resonanzfrequenz des Schwingungssystems eines mikromechanischen Bauelements auf eine Sollresonanzfrequenz können ebenfalls in zwei Strategietypen unterteilt werden, nämlich in eine Strategie, nach welcher quasi als einer der letzten Herstellungsschritte nichtreversible Änderungen an den mikromechanischen Bauelementen zur Anpassung der Resonanzfrequenz des Schwingungssystems vorgenommen werden, und eine Strategie, nach welcher die Resonanzfrequenz des Schwingungssystems während des Betriebs auf die Sollresonanzfrequenz korrigiert, wie z.B. über eine Regelschleife nachgeregelt, wird. Die erste Strategie ist freilich lediglich für die Kompensation dauerhafter Resonanzfrequenzabweichungen geeignet und kann bei einigen Anwendungen, die eine Kompensation auch der Resonanzfrequenzschwankungen benötigen, eine während des Betriebs erfolgende Resonanzfrequenzkorrektur nicht ersetzen.

Ein Beispiel für ein Vorgehen zur Resonanzfrequenzeinstellung nach der ersten Strategie ist beispielsweise in der Doktorarbeit von G. K. Fedder mit dem Titel "Simulation of microelectromechanical systems", 1994, insbesondere im Kapitel 2.7 auf den Seiten 59 - 66, beschrieben. Dort wird ein abstimmbarer Mikroresonator beschrieben, bei dem die Resonanzfrequenz eines über Biegebalken aufgehängten Schwingungskörpers dadurch einstellbar gemacht wird, daß die Biegebalken zunächst durch Stege an mehreren Fixierungspunkten entlang der Länge der Biegebalken fixiert werden, um anschließend nach der Herstellung nacheinander durchtrennt zu werden, um stufenweise die effektive Länge der Biegebalken zu vergrößern und damit die Federkonstante bzw. die Resonanzfrequenz zu verringern, bis eine Sollresonanzfrequenz erreicht ist. Die Abstimmung ist freilich, wie bereits oben erwähnt, nicht für eine Korrektur von Resonanzfrequenzschwankungen während des Betriebs geeignet. Zudem ist die Abstimmung irreversibel und nur in Richtung niedrigerer Resonanzfrequenzen möglich.

Zur Regelung der Resonanzfrequenz während des Betriebs existieren verschiedene Ansätze. In den US 6 331 909 und US 6 285 489 wird eine Resonanzfrequenzregelung beschrieben, bei der zur Änderung der Resonanzfrequenz der Umgebungsdruck variiert wird, wodurch sich die effektive Masse des bewegten Elements bzw. des Schwingungskörpers mittels der Gasbewegung und damit auch die Resonanzfrequenz des Feder-Masse-Systems ändert. Die hierfür notwendige Apparatur und der Regelkreis sind jedoch verhältnismäßig aufwendig. Ferner wird ein Ausführungsbeispiel beschrieben, bei dem die Feder des Feder-Masse-Systems mit einem gasabsorbierenden Material belegt ist, das bei Absorption die Materialeigenschaften und damit die Frequenz ändert. Auch hier besteht der Nachteil in dem verhältnismäßig hohen Aufwand. Zudem ist davon auszugehen, daß durch die Einschränkung der Auswahl der für die Feder zur Verfügung stehenden Materialien auf solche des gasabsorbierenden Typs die Güte des Systems herabgesetzt wird bzw, nicht optimal ist.

In den US 6 256 131 und US 6 285 489 wird ein Torsionsschwingungssystem beschrieben, bei dem ein Teil der sich drehenden Masse mittels elektrostatischer Kräfte von der Torsionsachse weg bzw. zu der Torsionsachse hin verschoben werden kann. Hierdurch ändert sich das Trägheitsmoment und damit wiederum die Resonanzfrequenz. Dieses Vorgehen ermöglicht zwar eine Regelung der Resonanzfrequenz, größere Abweichungen sind jedoch aufgrund der im allgemeinen geringen Translationswge der beweglichen Masse nicht zu korrigieren.

Die WO 98/44571A1 beschreibt die Einstellung von Betriebscharakteristika mikromechanischer Torsionsoszillatoren. Es sei möglich, die Resonanzfrequenz der Torsionsschwingungsmode eines Torsionsoszillators, der an einem wiederum torsionsmäßig aufgehängten Rahmen aufgehängt ist, zu verringern, indem die Resonanzfrequenz einer Schaukelschwingungsmode des drehbaren Rahmen verringert wird. Zu dem Zweck, letztere zu verringern, wird vorgeschlagen, unterhalb des Rahmens eine Elektrode anzuordnen, so dass das Anlegen einer Spannung zwischen der Elektrode und dem Rahmen effektiv zu einer Verringerung der Resonanzfrequenz des Rahmens und damit indirekt zu einer Verringerung der Resonanzfrequenz des Torsionsoszillators führt.

Die Aufgabe der vorliegenden Erfindung besteht folglich darin, ein Konzept zur Einstellung einer Resonanzfrequenz eines mikromechanischen Bauelements zu schaffen, die während des Betriebs des mikromechanischen Bauelements möglich und weniger aufwendig ist.

Diese Aufgabe wird durch ein mikromechanisches Bauelement gemäß Anspruch 1 und ein Verfahren zum Betreiben desselben gemäß Anspruch 15 gelöst.

Ein erfindungsgemäßes mikromechanisches Bauelement umfaßt ein Schwingungssystem, das einen Schwingungskörper und eine elastische Aufhängung, mittels der der Schwingungskörper. schwingfähig aufgehängt ist, aufweist, sowie eine Einrichtung zum Einstellen einer Resonanzfrequenz des Schwingungssystems durch Anlegen einer Spannungsdifferenz zwischen zumindest einem Teil des Schwingungskörpers und zumindest einer stationären Elektrode.

Ein erfindungsgemäßes Verfahren zum Betreiben eines mikromechanischen Bauelements mit einem Schwingungssystem, das einen Schwingungskörper und eine elastische Aufhängung, mittels der der Schwingungskörper schwingfähig aufgehängt ist, aufweist, umfaßt das Einstellen einer Resonanzfrequenz des Schwingungssystems durch Anlegen einer Spannungsdifferenz zwischen zumindest einem Teil des Schwingungskörpers und zumindest einer stationären Elektrode.

Der vorliegenden Erfindung liegt die Erkenntnis zugrunde, daß durch Anlegen einer Spannungsdifferenz zwischen zumindest einem Teil des Schwingungskörpers einerseits und einer oder mehreren stationären Elektroden andererseits bei geeigneter Anordnung der stationären Elektrode(n) eine virtuelle Änderung der Federkonstante der elastischen Aufhängung erzielt werden kann, die wiederum eine Änderung bzw. Einstellbarkeit des Schwingungssystems bzw. des Feder-Masse-Systems liefert. Die Einstellung ist stufenlos möglich. Zudem beschränken sich die vorzunehmenden Hinzufügungen zu dem mechanischen Schwingungssystem auf das Vorsehen elektrischer Strukturen, wie sie mittels mikromechanischer Herstellungsverfahren problemlos und kostengünstig herstellbar sind und wie sie bei elektrostatischer Anregung des Schwingungssystems ohnehin vorgesehen werden müssen.

Bei einem mikromechanischen Bauelement gemäß einem speziellen Ausführungsbeispiel der vorliegenden Erfindung ist neben der Einstellbarkeit der Resonanzfrequenz des Schwingungssystems durch Anlegen einer Spannungsdifferenz zwischen Schwingungskörper und stationärer Elektrode bzw. stationären Elektroden eine Einrichtung zur irreversiblen Korrektur von dauerhaften Resonanzfrequenzabweichungen vorgesehen. Hierdurch wird eine kombinierte Vorabeinstellungs- und Regelfähigkeit geliefert, um sowohl Resonanzfrequenzabweichungen als auch -schwankungen ausgleichen zu können. Hiermit wird die Ausbeute bei der Fertigung signifikant erhöht, da mikromechanische Bauelemente, die unmittelbar nach ihrer Herstellung eine Resonanzfrequenz aufweisen, die außerhalb des durch die Spannungsdifferenzanlegung ausgleichbaren Frequenzbereichs liegt, nicht ausgesondert werden müssen, sondern durch die irreversible Vorabkompensation derart manipuliert werden können, daß ihre Resonanzfrequenz ausreichend nah an der Sollresonanzfrequenz ist. Zum anderen wird durch die irreversible Vorabeinstellbarkeit die Möglichkeit geliefert, mikromechanische Bauelemente, die auf dieselbe Weise hergestellt wurden, für verwandte Anwendungen zu verwenden, die sich lediglich durch die gewünschte Resonanzfrequenz unterscheiden, wodurch wiederum die Herstellungskosten reduziert werden können.

Gemäß einem speziellen Ausführungsbeispiel der vorliegenden Erfindung umfaßt ein mikromechanisches Bauelement einen Bauelementrahmen und einen über zwei Torsionsfedern zu Kippbewegungen fähigen, aufgehängten Schwingungskörper. Die Federn sind jeweils an einem Anker fest mit dem Bauelementrahmen verbunden. Zusätzlich sind Stege vorgesehen, um die Federn in ihrer Bewegungsfreiheit einzuschränken. Bei Fertigung sind die mikromechanischen Bauelemente derart ausgelegt, daß die Resonanzfrequenz a priori höher als die gewünschte Sollresonanzfrequenz ist. Je nach Fertigungsschwankung bzw. Resonanzfrequenzabweichung werden dann verschieden viele der Stege durchtrennt, um die Bewegungsfreiheit zu erhöhen und damit die Federsteifigkeit der Federn und die Resonanzfrequenz zu verringern und letztere an die Sollresonanzfrequenz anzunähern. Während des Betriebs wird dann durch Anlegen einer Spannungsdifferenz zwischen Schwingungskörper und geeignet angeordneten stationären Elektroden eine virtuelle Federkonstantenerhöhung bzw. Verringerung erzielt.

Bei einem Ausführungsbeispiel sind die stationären Elektroden im Bauelementrahmen integriert, um ein Potentialminimum an der Ruhelage zu erzeugen, was einer virtuellen Federkonstantenerhöhung entspricht. Bei einem anderen Ausführungsbeispiel sind die stationären Elektroden ober- bzw. unterhalb zu verschiedenen Seiten der Schwenkachse angeordnet, um ein Potentialmaximum an der durch die Torsionsfedern definierten Ruhelage zu erzeugen, wodurch eine virtuelle Federkonstantenverringerung erzielt wird.

Bevorzugte Ausführungsbeispiele der vorliegenden Erfindung werden nachfolgend bezugnehmend auf die beiliegenden Zeichnungen näher erläutert. Es zeigen:
- Fig. 1: eine Raumdarstellung des Schwingungssystems eines mikromechanischen Bauelements gemäß einem Ausfüh- rungsbeispiel der vorliegenden Erfindung;
- Fig. 2a: einen Querschnitt eines mikromechanischen Bauele- ments mit dem Schwingungssystem von Fig. 1 durch die Linie A-A und einer Anordnung stationärer Elektroden gemäß einem Ausführungsbeispiel der vorliegenden Erfindung;
- Fig. 2b: einen Querschnitt eines mikromechanischen Bauele- ments mit dem Schwingungssystem von Fig. 1 durch die Linie A-A und einer Anordnung stationärer Elektroden gemäß einem weiteren Ausführungsbei- spiel der vorliegenden Erfindung;
- Fig. 3: eine Raumdarstellung eines Schwingungssystems eines mikromechanischen Bauelements gemäß einem weiteren Ausführungsbeispiel der vorliegenden Er- findung, bei dem die Elektrodenanordnungen von Fig. 2a und 2b möglich sind;
- Fig. 4: eine Draufsicht eines Schwingungssystems eines mikromechanischen Bauelements gemäß einem weite- ren Ausführungsbeispiel der vorliegenden Erfin- dung, bei dem die Elektrodenanordnungen von Fig. 2a und 2b möglich sind;
- Fig. 5a: und 5c ein mikromechanischen Bauelements gemäß einem weiteren Ausführungsbeispiel, bei dem eine Elektrodenkonfiguration vorgesehen ist, die zur Schwingungserregung, virtuellen Resonanzfrequenz- änderung und zur Regelung der Resonanzfrequenz auf eine Erregerfrequenz geeignet ist, wobei Fig. 5a und 5c Draufsichten und Fig. 5b eine Quer- schnittansicht entlang der Linie A-A von Fig. 5a und Fig. 5c zusätzlich eine Regelschaltung zur Resonanzregelung zeigen; und
- Fig. 6a: bis 6c Draufsichten von Schwingungssystemen mit Biegebalken als elastischer Aufhängung, bei denen die vorliegende Erfindung implementiert werden kann.

Bevor im folgenden die vorliegende Erfindung anhand der beiliegenden Zeichnungen näher erläutert wird, wird darauf hingewiesen, daß die Zeichnungen zur besseren Verständlichkeit nicht maßstabsgerecht ausgeführt sind. Zudem sind in den Figuren gleiche Elemente mit gleichen Bezugszeichen versehen, wobei eine wiederholte Beschreibung dieser Elemente weggelassen wird.

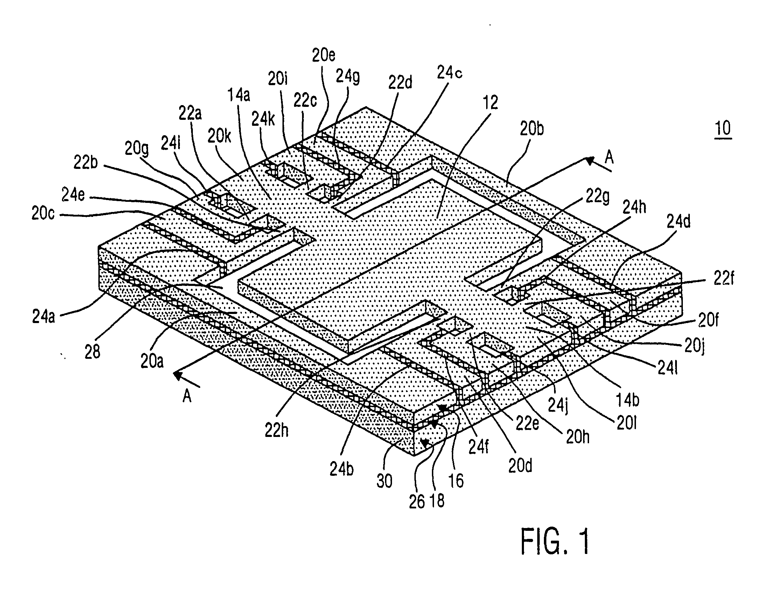

Fig. 1 zeigt ein Ausführungsbeispiel eines Schwingungssystems eines mikromechanischen Bauelements, das allgemein mit 10 angezeigt ist, im Rahmen dessen die vorliegende Erfindung implementierbar ist, wie es im folgenden erläutert werden wird. Das mikromechanische Bauelement 10 des vorliegenden Ausführungsbeispiels stellt einen mikromechanischen Spiegel dar, wie er beispielsweise bei Mikroscannern eingesetzt wird, um einen modulierten Lichtstrahl mit einer vorbestimmten Sollfrequenz abzulenken, um den Lichtstrahl in einem Bildfeld mit der Sollfrequenz hin- und herzubewegen, wodurch durch den sich auf dem Bildfeld bewegenden modulierten Lichtfleck auf dem Bildfeld ein Bild erzeugt wird. Es wird jedoch darauf hingewiesen, daß die vorliegende Erfindung freilich auch bei anderen mikromechanischen Bauelementen mit einem Schwingungssystem verwendet werden kann.

Das mikromechanische Bauelement 10 umfaßt ein Schwingungssystem aus einem Schwingungskörper 12, der als Spiegelplatte dient, und eine elastische Aufhängung 14 bzw. 14a und 14b. Sowohl Schwingungskörper 12 als auch elastische Aufhängung 14 sind in einer Halbleiterschicht 16 gebildet. Unterhalb der Halbleiterschicht 16, die beispielsweise aus hochdotiertem Silizium besteht, befindet sich eine vergrabene Isolationsschicht 18, die bei der Bildung von Schwingungskörper 12 und Aufhängung 14 in der Schicht 16 als Ätzstopp gedient hat. In der Schicht 16 sind ferner ein Rahmen 20 bzw. 20a-201 und Stege 22 bzw. 22a-22h gebildet. Der Bauelementrahmen 20 besteht aus mehreren Teilgebieten 20a - 201, die jeweils durch Isolationsgräben 24a - 241 voneinander getrennt sind und aus einem isolierenden Material, wie z.B. Siliziumdioxid, bestehen. Die Gebiete 20k und 201 dienen als die sogenannten Anker für die Aufhängung 14.

Genauer ausgedrückt, besteht die Aufhängung 14 aus zwei flachen und länglichen Torsionsfedern 14a und 14b, welche an einem Ende an dem Anker 20k bzw. dem Anker 201 und an dem anderen Ende an einer Mitte einer jeweils gegenüberliegenden länglichen Seite des rechteckigen, als Spiegel dienenden Schwingungskörpers 12 befestigt sind. Zusätzlich zu der Befestigung an den Ankern 20k und 201 sind die Torsionsfedern 14a und 14b entlang ihrer Länge zwischen den Ankern 20k bzw. 201 und dem Schwingungskörper 12 an Fixierungspunkten am lateralen Umfang durch die Stege 22a - 22h fixiert. Genauer ausgedrückt, fußen die Stege 22a - 22h entlang des lateralen Umfangs der Torsionsfedern 14a und 14b an vorbestimmten Fixierungspunkten, wobei der Steg 22a an dem Rahmengebiet 20g, der Steg 22b an dem Gebiet 20c, der Steg 22c an dem Gebiet 20i, der Steg 22d an dem Gebiet 20e, der Steg 22e an dem Gebiet 20h, der Steg 22f an dem Gebiet 20j, der Steg 22g an dem Gebiet 20f und der Steg 22h an dem Gebiet 20d des Bauelementrahmens 20 endet bzw. dort befestigt ist.

Die Stege 22a - 22h fixieren die Torsionsfedern 14a, 14b jeweils paarweise an jeweils gegenüberliegenden Fixierungspunkten entlang der Länge der Torsionsfedern 14a, 14b. Die Fixierungspunkte der Stege 22b, 22d bzw. 22h und 22g befinden sich etwas näher an dem Schwingungskörper 12, während sich die Fixierungspunkte der Stege 22a, 22c bzw. 22f, 22e etwas näher an dem Anker 20k, 201 befinden.

Bei der Herstellung der Strukturen 12-24, d.h. des Schwingungskörpers 12, der Aufhängung 14, des Bauelementrahmens 20, der Stege 22 und der Isolationsgräben 24, in der Halbleiterschicht 16 ist beispielsweise ein geeignetes Ätzverfahren verwendet worden, bei welchem die vergrabene Isolationsschicht 18 als Ätzstopp diente. Alle Strukturen weisen deshalb die gleiche Dicke, nämlich die Dicke der Halbleiterschicht 16 auf. Die Isolationsgräben sind mit einem isolierenden Material aufgefüllt, so daß sich ein zusammenhängender und stabiler Bauelementrahmen 20 ergibt.

Der als Spiegel dienende Schwingungskörper 12 ist als rechteckige Platte gebildet. Die Torsionsfedern 14a, 14b, die in Form länglicher Streifen gebildet sind, fußen an der Mitte jeweils einer der gegenüberliegenden länglichen Seiten des Schwingungskörpers 12 und enden an den Ankern 20k, 201. Auf diese Weise wird es dem Schwingungskörper 12 ermöglicht, um eine durch die Torsionsfedern 14a, 14b verlaufende Schwenkachse zu schwenken. Die Torsionsfedern 14a, 14b definieren hierbei eine Ruhelage, bei der sich der Schwingungskörper 12 in der Ebene der Schicht 16 befindet. Bei Auslenkung des Schwingungskörpers 12 aus der Ruhelage durch Verkippen des Schwingungskörpers 12 um die durch die Torsionsfedern 14 definierte Schwenkachse bewirken die Torsionsfedern 14a, 14b eine Rückstellkraft bzw. ein Drehmoment zurück zur Ruhelage hin.

Getragen wird die gesamte Konstruktion von einem Substrat 26, welches sich unterhalb der vergrabenen Isolationsschicht 18 befindet und beispielsweise ebenfalls aus Silizium gebildet ist. Substrat 26, Isolationsschicht 18 und Halbleiterschicht 16 können beispielsweise vor der Herstellung als SOI- (Silicon On Isolator) Wafer vorbereitet sein, um in demselben gleichzeitig eine Mehrzahl von mikromechanischen Bauelementen 10 zu bilden, die anschließend vereinzelt werden. Um eine Auslenkung des Schwingungskörpers 12 aus seiner Ruhelage überhaupt erst zu ermöglichen, sind unterhalb des Schwingungskörpers und der Torsionsfedern 14a, 14b die Isolationsschicht 18 und das Substrat 26 entfernt, um einen Hohlraum 28 zu bilden. Die in der Halbleiterschicht 16 gebildeten Strukturen werden somit lediglich am Außenrand der Schicht 16 durch einen Substratrahmen 30 getragen, auf welchem die Schicht 16 bzw. die darin gebildeten Strukturen über den nicht entfernten Rest der vergrabenen Isolationsschicht 18 aufliegen. Zur Herstellung des Hohlraums 28 sind beispielsweise nach der Strukturierung der Halbleiterschicht 16 durch geeignete zwei Ätzschritte das Substrat 26 und die vergrabene Isolationsschicht 18 bis auf Randgebiete bzw. den lateralen Rand der Schicht 16 entfernt worden.

Der Schwingungskörper ist somit bis auf die Torsionsfedern 14a, 14b ungehaltert. Die Torsionsfedern 14a, 14b sind lediglich an den Ankern 20k und 201 sowie den Fixierungspunkten der Stege 22a - 22h fixiert. Aufgrund der Isolationsgräben 24a - 241 und der vergrabenen Isolationsschicht 18 sind die einzelnen Gebiete des in der Schicht 16 gebildeten Bauelementrahmens 20 untereinander elektrisch isoliert. Lediglich über die Stege 22a - 22h existiert eine elektrische Verbindung zwischen den Gebieten 20c, 20g, 20i und 20e zu dem Anker 20k bzw. der Gebiete 20d, 20h, 20j, 20f zu dem Anker 201.

Das in Fig. 1 gezeigte mikromechanische Bauelement 10 liefert bereits eine Einstellbarkeit der Resonanzfrequenz des Schwingungssystems aus Schwingungskörper 12 und elastischer Aufhängung 14 auf diskrete Weise, um die in der Beschreibungseinleitung beschriebenen herstellungsbedingten dauerhaften Resonanzfrequenzabweichungen aufgrund von beispielsweise Schichtdickevariationen der Schicht 16 oder dergleichen von der Sollresonanzfrequenz auszugleichen, wobei diese Einstellbarkeit im folgenden näher erläutert werden wird. Die Einstellung der Resonanzfrequenz wird über die Federsteifigkeit des Feder-Masse-Systems bzw. des Schwingungssystems aus Schwingungskörper 12 und elastischer Aufhängung 14 ermöglicht. Die Federsteifigkeit wird dadurch geändert, daß beispielsweise, unmittelbar nachdem der in Fig. 1 gezeigte Aufbau des mikromechanischen Bauelements 10 erhalten worden ist, die effektive, d.h. sich elastisch verformende, Federlänge der Torsionsfedern 14a, 14b durch Lösen einer bzw. mehrerer Festkörperverbindungen durch die Stege 22a - 22h zwischen den Torsionsfedern 14a, 14b und dem Bauelementrahmen 20 von den Stegen näher dem Schwingungskörper 12 her beginnend verlängert wird. Hierbei kann jede Stegverbindung separat für den Lösevorgang ausgewählt werden.

Das in Fig. 1 gezeigte Ausführungsbeispiel des mikromechanischen Bauelements 10 zeichnet sich im Hinblick auf das Lösen der Festkörperstegverbindungen insbesondere dadurch aus, daß es auf einfache Weise durchgeführt werden kann. Ein Ausführungsbeispiel für das Lösen der Festkörperverbindungen sowie eine Erörterung der hierdurch ermöglichten Einstellbarkeit der Resonanzfrequenz des Schwingungssystems auf irreversible und diskrete Weise wird nun erläutert.

Die einzelnen Gebiete 20a - 201 des Bauelementrahmens 20 werden mit jeweils einem Kontakt (nicht gezeigt) versehen, um dieselben elektrisch kontaktierbar zu machen, wie z.B. über die Drahtbondtechnik oder dergleichen. Die Halbleiterschicht 16 ist zudem leitend hergestellt. Zur Einstellung der Resonanzfrequenz in Richtung einer kleineren Resonanzfrequenz des Feder-Masse-Systems aus Schwingungskörper 12 und Aufhängung 14 können nun die Stege 22a - 22h nacheinander entfernt werden, wobei zunächst diejenigen Stege entfernt werden, welche dem beweglichen Körper 12 bzw. dem Schwingungskörper 12 am nächsten liegen, d.h. 22b, 22d, 22h, 22g. Dadurch vergrößert sich die effektive Länge der Torsionsfedern 14a, 14b und dieselben weisen eine geringere Steifigkeit auf, wodurch sich wiederum die Resonanzfrequenz des Schwingungssystems verringert.

Jeder Steg 22a - 22h kann einzeln und unabhängig von den anderen entfernt werden. Beispielhaft wird der Durchtrennungsvorgang anhand des Stegs 22b veranschaulicht. Zwischen dem Gebiet 20c, das durch die Isolationsgräben 24a und 24e begrenzt wird, und dem Ankergebiet 20k wird eine Spannung angelegt. Diese Spannung hat einen Stromfluß entlang eines elektrischen Weges zur Folge, der einen Teil der Torsionsfeder 14a und den zu durchtrennenden Steg 22c beinhaltet. Da der Steg 22c im Vergleich zur Feder 14a aufgrund seiner Abmessungen einen kleineren Querschnitt und gegebenenfalls aufgrund einer speziellen, geringeren Dotierung beispielsweise eine geringere spezifische Leitfähigkeit aufweist und er damit den größten Widerstand entlang des elektrischen Wegs zwischen Ankergebiet 20k und Gebiet 20c darstellt, erwärmt sich der Steg 22b stärker als die Feder 14a. Bei geeignet hoher Spannung kommt es zum Aufschmelzen des Stegs 22b, was eine Trennung desselben zur Folge hat, und damit folglich auch zu einer Verringerung der Federsteifigkeit der Torsionsfeder 14a führt. Die Verringerung der Federsteifigkeit 14a ergibt sich aus der Tatsache, daß bei Durchtrennung des Stegs 22c die effektive Länge der Torsionsfeder 14a erhöht wird, die zur Torsion während einer Schwingung des Schwingungskörpers 12 zur Verfügung steht. Derselbe Durchtrennungsvorgang kann an jedem weiteren Steg durchgeführt werden, da jeder Steg den größten Widerstand entlang eines elektrischen Wegs zwischen Ankergebiet 20k und einem der Gebiete 20c, 20g, 20i, 20e bzw. dem Ankergebiet 201 und einem der Gebiete 20d, 20h, 20j und 20f darstellt.

Aus Symmetriegründen könnte es sinnvoll sein, die Stege stets doppelpaarweise zu durchtrennen, d.h. immer die vier Stege mit gleicher Entfernung zum Schwingungskörper 12, also zunächst die dem Schwingungskörper 12 nächstgelegenen Stege 22b, 22d, 22h, 22g und dann die Stege 22a, 22c, 22e und 22f.

Wie es aus der vorhergehenden Erörterung deutlich wurde, kann durch die Stegdurchtrennung lediglich eine Einstellung der Resonanzfrequenz in Richtung niedrigerer Frequenzen erzielt werden. Die Einstellung ist zudem irreversibel. Bei der Fertigung des mikromechanischen Bauelements 10 sollten die Fixierungspunkte deshalb derart gewählt werden, daß die Resonanzfrequenz des Schwingungskörpers 12 in dem Zustand nichtdurchtrennter Stege a priori höher als die gewünschte Sollresonanzfrequenz ist.

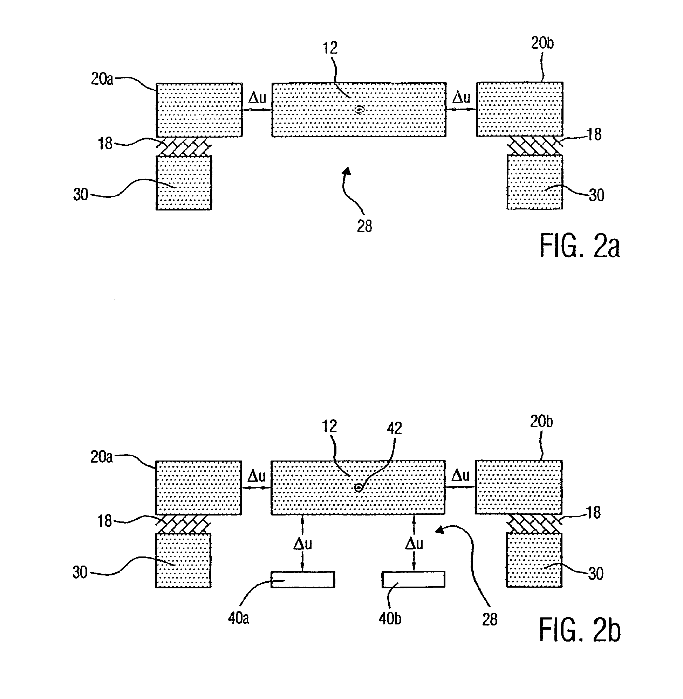

Wie ebenfalls aus der vorhergehenden Erörterung deutlich wurde, ist die Einstellbarkeit, die das mikromechanische Bauelement 10 von Fig. 1 liefert, der Resonanzfrequenz lediglich in diskreten Schritten und auch nur mit konstanter Wirkung für den Rest der Lebensdauer des mikromechanischen Bauelements 10 möglich. Korrekturen bzw. Regelungen der Resonanzfrequenz, um Umgebungsschwankungen und deren Auswirkungen auf die Resonanzfrequenz während der Betriebsdauer des mikromechanischen Bauelements 10 auszugleichen, sind nicht möglich. Gemäß zweier Ausführungsbeispiele, die im folgenden Bezug nehmend auf Fig. 2a und 2b beschrieben werden, wird deshalb die im vorhergehenden beschriebene Resonanzfrequenzeinstellbarkeit des mikromechanischen Bauelements 10 durch Durchtrennen der Stege um eine weitere Einstellbarkeit ergänzt, die auch während des Betriebs möglich ist. Wie es später detaillierter dargelegt wird, wird hierzu ein elektrostatisches Verfahren verwendet, bei dem zwischen einem Teil des Schwingungskörpers, der als bewegte Elektrode dient, und einer festen Elektrode eine konstante Spannungsdifferenz angelegt wird, wodurch je nach Elektrodenkonfiguration bzw. -anordnung bei Auslenkung des Schwingungskörpers eine hin zur Ruhelage (Fig. 2a) oder hin zum Wendepunkt der Schwingung (Fig. 2b) beschleunigende Kraft bewirkt wird, welche einer effektiven Änderung der Federsteifigkeit der Torsionsfedern entspricht. Diese effektive Änderung der Federsteifigkeit bewirkt wiederum eine Änderung der Resonanzfrequenz des Schwingungssystems, und zwar in Abhängigkeit von dem Betrag der anliegenden Spannungsdifferenz, wodurch die Resonanzfrequenz regelbar bzw. im Betrieb einstellbar wird.

In Fig. 2a und 2b, die sich auf jeweils ein Ausführungsbeispiel für eine Elektrodenkonfiguration beziehen, die die soeben beschriebene zusätzliche Einstellbarkeit liefern, stellen Querschnitte des mikromechanischen Bauelements 10 von Fig. 1 bzw. von dessen Schwingungssystem entlang der mit A-A in Fig. 1 angezeigten Ebene dar. Bei beiden Figuren, Fig. 2a und 2b, befindet sich der Schwingungskörper 12 in seiner Ruhelage.

Bezug nehmend auf Fig. 2a kann eine Resonanzfrequenzeinstellung im Betrieb des mikromechanischen Bauelements dadurch erzielt werden, daß eine Spannung zwischen Schwingungskörper 12 einerseits und einem Teil des Bauelementrahmens 20 andererseits angelegt und variiert wird. Wie es in Fig. 2a gezeigt ist, werden diejenigen Gebiete des Bauelementrahmens als feste Gegenelektrode zu dem die bewegliche Elektrode darstellenden Schwingungskörper 12 verwendet, welche denjenigen Teilen des Schwingungskörpers 12 gegenüberliegen, die bei Auslenkung des Schwingungskörpers 12 aus der Ruhelage den größten Weg zurücklegen, nämlich die Gebiete 20a und 20b, die den Kopfenden des Schwingungskörpers 12 gegenüberliegen.

Bei der Bewegung des Schwingungskörpers 12 wirkt die durch die Spannungsdifferenz ΔU zwischen Schwingungskörper 12 einerseits und Gebiet 20a bzw. 20b andererseits induzierte elektrische Kraft bzw. das durch die Spannungsdifferenz induzierte elektrische Drehmoment stets beschleunigend in Richtung der Ruhelage des Feder-Masse-Systems. Die Ruhelage des Schwingungssystems, wie sie durch die Torsionsfedern 14a, 14b (Fig. 1) definiert ist, ändert sich durch die Spannungsdifferenz ΔU aufgrund der Symmetrie der Anordnung nicht, sondern stimmt mit der durch die Spannungsdifferenz bzw. die elektrostatisch bewirkten Kräfte definierten Ruhelage überein oder weicht nur wenig von ihr ab.

Die Wirkung des elektrostatisch bewirkten Drehmoments läßt sich effektiv durch eine Vergrößerung der Federkonstante des Schwingungssystems beschreiben. Um dies zu verstehen, betrachte man beispielsweise die Abhängigkeit des durch die Torsionsfedern 14a, 14b bewirkten Drehmoments von einer Auslenkung α um die Ruhelage bei α = 0. Bei genügend kleinen Auslenkungen ist die Abhängigkeit linear. Die Steigung entspricht der Federkonstante der Torsionsfedern. Das durch die Spannungsdifferenz bewirkte elektrostatische Drehmoment ist dem Torsionsfederdrehmoment gleichgerichtet und in der Nähe der Ruhelage von α = 0 ebenfalls linear. Das Gesamtdrehmoment besitzt in Abhängigkeit von der Auslenkung α somit eine größere Steigung, was wiederum einer virtuellen Erhöhung der Federsteifigkeit bzw. Federkonstante der Torsionsfedern entspricht. Abhängig von dem Betrag der anliegenden Spannungsdifferenz ΔU kann also die Resonanzfrequenz hin zu größeren Werten geregelt werden, da die Resonanzfrequenz wiederum eine Funktion der effektiven Federkonstante ist.

Bezug nehmend auf die vorhergehende Beschreibung wird darauf hingewiesen, daß zur Erzeugung der Spannungsdifferenz ΔU entweder die Gebiete 20a und 20b des Bauelementrahmens 20 selbst als feste Elektrode verwendet werden können, um dieselben auf ein bestimmtes elektrisches Potential zu legen, oder daß dieselben mit einer metallischen Beschichtung versehen sein können. Das elektrische Potential des Schwingungskörpers 12 kann über die elektrische Verbindung definiert werden, die durch die Torsionsfedern geliefert wird. Statt dessen ist es jedoch ebenfalls möglich, daß der Schwingungskörper eine metallische Beschichtung als bewegliche Elektrode aufweist, die gleichzeitig beispielsweise als spiegelnde Beschichtung dienen kann und aus beispielsweise A1 besteht.

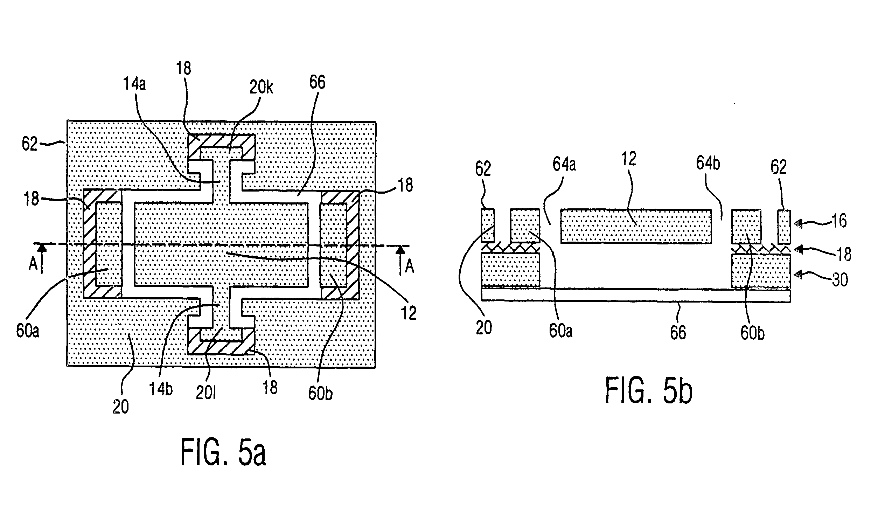

Anknüpfend an die vorhergehende Beschreibung bezugnehmend auf Fig. 1 betreffend die Einstellung der Resonanzfrequenz des Schwingungssystems durch irreversible Durchtrennung einzelner Stege kann nun unter Vorsehen der Elektrodenkonfiguration, wie sie in Fig. 2a gezeigt ist, an dem mikromechanischen Bauelement 10 durch Variieren der Spannungsdifferenz ΔU die Resonanzfrequenz, wie sie durch das Schwingungssystem nach Durchtrennung der Stege definiert ist, bis zu einem maximalen Wert auf kontinuierliche Weise erhöht werden, der durch die maximale Spannungsdifferenz definiert ist. Ein Beispiel dafür, wie unter Verwendung der Elektrodenkonfiguration nach Fig. 2a die Resonanzfrequenz des Schwingungssystems auf eine bestimmte Sollresonanzfrequenz eingeregelt werden kann, wird im folgenden Bezug nehmend auf Fig. 5a-5c erläutert werden.

Fig. 2b zeigt ein Ausführungsbeispiel für eine Elektrodenkonfiguration zur Einstellung der Resonanzfrequenz des Schwingungssystems aus Schwingungskörper 12 und elastischer Aufhängung des mikromechanischen Bauelements 10 von Fig. 1 während des Betriebs, bei der anstelle der Verwendung der Gebiete 20a, 20b des Bauelementrahmens in der Schicht 16 als feste Elektroden 40a und 40b feste Elektroden unterhalb des Schwingungskörpers 12 verwendet werden. Die Gegenelektroden 40a und 40b sind ortsfest angebracht und liegen dem Schwingungskörper 12 über den Hohlraum 28 in gleichem Abstand gegenüber, wenn der Schwingungskörper 12 sich in seiner Ruhelage befindet. Genauer gesagt sind die Gegenelektroden 40a und 40b parallel zur Ruhelage des Schwingungskörpers 12 ausgerichtet und symmetrisch zu einer Ebene angeordnet, die durch die Drehachse 42 und senkrecht zum Schwingungskörper 12 in seiner Ruhelage verläuft. Auf diese Weise liegen die Gegenelektroden 40a und 40b denjenigen Teilen des Schwingungskörpers 12 gegenüber, die bei Schwingung des Schwingungskörpers 12 der größten Auslenkung aus der Ruhelage unterliegen.

Liegt zwischen den Gegenelektroden 40a und 40b einerseits und dem beweglichen Körper 12 andererseits eine elektrische Spannungsdifferenz ΔU an, so bewirkt die induzierte elektrostatische Kraft bzw. das induzierte elektrostatische Drehmoment eine Verringerung der Federkonstante des Feder-Masse-Systems. Folglich ist durch die Elektrodenkonfiguration nach Fig. 2b die Resonanzfrequenz in Richtung niedrigerer Resonanzfrequenzen einstellbar. Um dies zu verstehen, überlege man sich, daß in der Ruhelage, wie sie in Fig. 2b gezeigt ist, kein Drehmoment auf den Schmingungskörper 12 ausgeübt wird, da das elektrostatische Drehmoment aufgrund der Spannungsdifferenz bezüglich der Gegenelektrode 40a und das bewirkte Drehmoment durch die Spannungsdifferenz bezüglich der Gegenelektrode 40b aus Symmetriegründen gleich ist. Wird jedoch der Schwingungskörper 12 beispielsweise in Uhrzeigerrichtung, wie in Fig. 2b betrachtet, ausgelenkt, so ist der Abstand zwischen der Gegenelektrode 40b und dem Schwingungskörper 12 kleiner als der zu der Gegenelektrode 40a, so daß die durch die Gegenelektrode 40b bewirkte Anziehungskraft größer als die durch die Gegenelektrode 40a bewirkte ist. Folglich wird durch die Spannungsdifferenz ΔU bei Auslenkung des Schwingungskörpers 12 in Uhrzeigersinnrichtung auf denselben ein Drehmoment in derselben Richtung bewirkt. Insgesamt definiert die Elektrodenkonfiguration von Fig. 2b folglich ein energetisches Potentialmaximum an der Ruhelage des Schwingungskörpers 12, während die Elektrodenkonfiguration von Fig. 2a ein energetisches Potentialminimum in der Ruhelage definierte. Dementsprechend bewirkt die Elektrodenkonfiguration gemäß Fig. 2b je nach Spannungsdifferenz zwischen Schwingungskörper 12 einerseits und Gegenelektroden 40a, 40b andererseits eine mehr oder weniger große virtuelle Verringerung der Federkonstanten des Schwingungssystems und somit auch eine Verringerung der Resonanzfrequenz. Ein Beispiel für eine Regelung der Resonanzfrequenz eines Schwingungssystems auf eine Sollresonanzfrequenz mittels einer Elektrodenkonfiguration gemäß Fig. 2b wird im folgenden Bezug nehmend auf Fig. 5a-5c erläutert werden.

Das Implementieren der Elektrodenkonfiguration von Fig. 2a kann durch Bedampfen entsprechender leitfähiger Elektroden auf dem Bauelementrahmen 20 und dem Schwingungskörper 12 realisiert werden. Die Elektrodenkonfiguration gemäß Fig. 2b erfordert lediglich beispielsweise das metallische Beschichten des Schwingungskörpers 12 sowie das Vorsehen der festen Elektroden unterhalb des Schwingungskörpers 12. Bei alternativen Ausführungsbeispielen können anstatt Bedampfungen bzw. Beschichtungen als die Elektroden auch Teile einer entsprechenden Schicht verwendet werden, falls diese aus leitfähigem Material besteht.

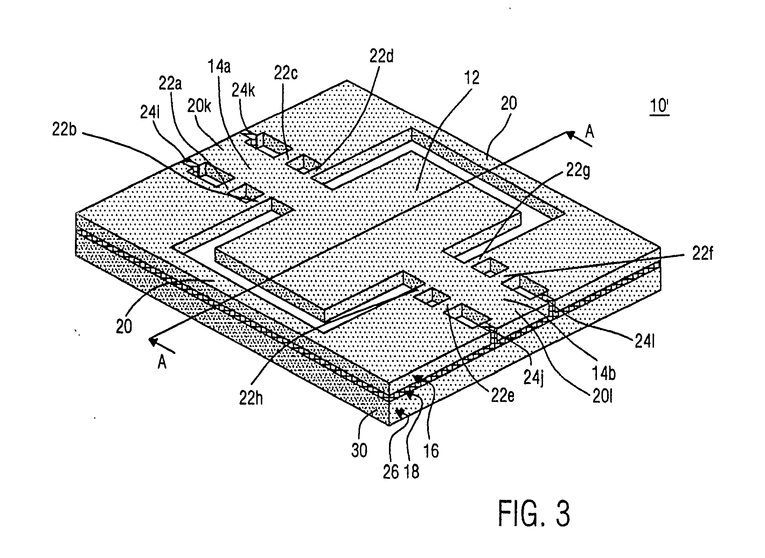

Bezug nehmend auf Fig. 3 wird zunächst ein weiteres Ausführungsbeispiel für ein Schwingungssystem eines mikromechanisches Bauelement beschrieben, welches demjenigen von Fig. 1 strukturell ähnlich ist, und bei dem die in Fig. 2a und 2b gezeigten Elektrodenkonfigurationen ebenfalls problemlos anwendbar sind, wobei aus diesem Grund in Fig. 3 auch die Schnittebene A-A eingezeichnet ist.

Das mikromechanische Bauelement von Fig. 3, welches allgemein mit 10' angezeigt ist, unterscheidet sich von demjenigen von Fig. 1 lediglich dadurch, daß die Stege 22a - 22h nicht durch Isolationsgräben voneinander elektrisch getrennt sind. Anders ausgedrückt, sind unter den Isolationsgräben von Fig. 1 lediglich die Isolationsgräben 24i, 24j, 24k und 241 vorgesehen, die die Ankergebiete 20k und 201 von dem Rest des Bauelementrahmens 20 trennen. Die Entfernung der Stege und damit die Einstellung der Resonanzfrequenz kann bei diesem Ausführungsbeispiel durch ein nichtelektrisches Verfahren, also nicht durch Aufschmelzen, sondern beispielsweise durch ein Laserstrahlverdampfungs-oder Ionenstrahlabtragungsverfahren oder durch Laserstrahlschmelzen erfolgen. Im Unterschied zu dem Ausführungsbeispiel von Fig. 1 ist aufgrund der anders gearteten Durchtrennungsverfahren für die Stege 22a - 22h kein leitfähiges Material für die Schicht 16 erforderlich. Jedes andere Material ist deshalb ebenfalls einsetzbar.

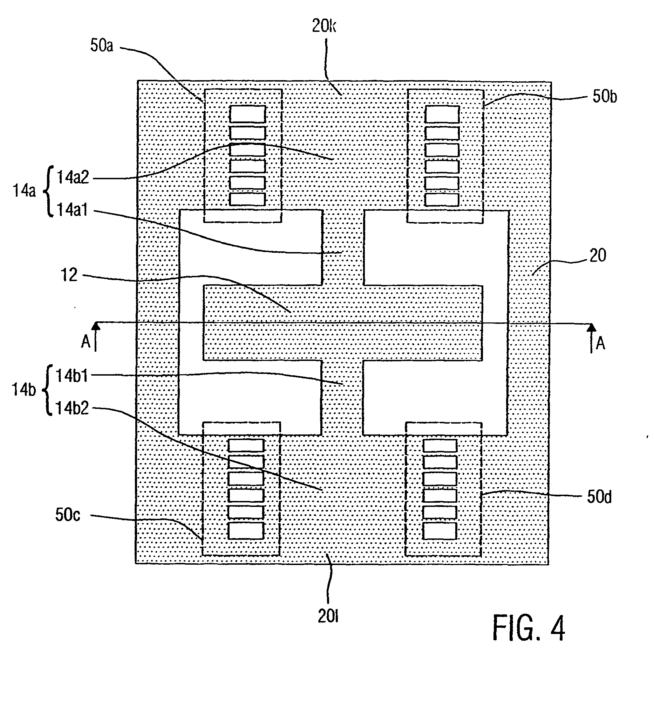

Ein weiteres Ausführungsbeispiel für ein Schwingungssystem eines mikromechanisches Bauelements, bei dem die Elektrodenkonfigurationen gemäß Fig. 2a und 2b zur Einstellung der Resonanzfrequenz des Schwingungssystems während des Betriebs verwendet werden können, wie es durch die Schnittebene A-A gezeigt ist, ist in Fig. 4 gezeigt. Von den Ausführungsbeispielen gemäß Fig. 1 und 3 unterscheidet sich das Schwingungssystem der mikromechanische Bauelements gemäß Fig. 4 lediglich durch eine spezielle Ausgestaltung der Torsionsfedern 14a und 14b. Isolationsgräben wie in Fig. 1 oder 3 sind in Fig. 4 zur besseren Übersichtlichkeit nicht dargestellt, können jedoch je nach zu verwendendem Durchtrennungsverfahren entsprechend dem Ausführungsbeispiel von Fig. 1 oder Fig. 3 vorgesehen werden.

Da die Abstände der Stege durch die Auflösung des verwendeten Strukturierungsverfahrens begrenzt sind, ist die Auflösung der Einstellbarkeit durch Stegdurchtrennung zunächst begrenzt. Eine feinere Einstellung der Resonanzfrequenz kann erzielt werden, wenn die Torsionsfedern 14a und 14b im Bereich der Stege breiter sind als in demjenigen Bereich, der im vorhinein, also auch ohne Durchtrennung jedweden Steges, frei für elastische Verformungen während der Auslenkung des Schwingungskörpers 12 ist. Zur feineren Einstellbarkeit setzen sich folglich die Torsionsfedern 14 und 14b des mikromechanischen Bauelements gemäß Fig. 4 aus zwei Teilen zusammen, nämlich einem lateral schmaleren Federteil 14a1 bzw. 14b1 und einem lateral breiteren Federteil 14a2 bzw. 14b2. Entlang der Länge der Torsionsfedern 14a bzw. 14b sind die Federteile 14a1 bzw. 14b1 an dem Schwingungskörper 12 angeordnet, während die Federteile 14b2 bzw. 14a2 an der Seite der Anker 20k, 201 angeordnet sind.

Wie es zu sehen ist, beschränkt sich der Abschnitt des lateralen Umfangs der Torsionsfedern 14a und 14b, an welchem die Stege die Torsionsfedern 14a bzw. 14b in ihrer Bewegungsfreiheit einschränken, auf die lateral breiten Federteile 14a2 bzw. 14b2, wobei diese Umfangs- bzw. Randabschnitte mit gestrichelten Linien 50a, 50b, 50c und 50d angezeigt sind. Nur die breiten Federteile 14a2 bzw. 14b2 sind somit über die mehreren Stege in den Bereichen 50a - 50d (vorliegend jeweils sechs Stege pro Bereich) in ihrer Bewegungsfreiheit eingeschränkt.

Aufgrund des größeren Querschnitts der Torsionsfedern 14a bzw. 14b an den Teilen 14a2 und 14b2 im Vergleich zu den schmäleren Teilen 14a1 bzw. 14b1 bewirkt die Durchtrennung der Stege nacheinander von dem Schwingungskörper 12 her eine vergleichsweise geringere Erhöhung der Bewegungsfreiheit bzw. Verringerung der Federsteifigkeit der Torsionsfedern 14a bzw. 14b verglichen zu dem Fall, da die Torsionsfedern 14a und 14b durchgehend so schmal wie die Teile 14a1 bzw. 14b1 wären, da der durch diese Durchtrennung hinzukommende, an der elastischen Verformung der Torsionsfedern 14a und 14b teilnehmende Teil der Torsionsfedern nur einen geringen Beitrag zur Elastizität der Feder liefert. Hinsichtlich der anderen Eigenschaften entspricht das mikromechanische Bauelement von Fig. 4 den Ausführungsbeispielen von Fig. 1 und 3.

Eine Abwandlung des in Fig. 4 gezeigten Ausführungsbeispiels besteht darin, die Ausbildung des verbreiterten Teils der Torsionsfedern nur auf einer Seite, d.h. nur bei einer der Torsionsfedern, durchzuführen, oder den Grad an Verbreiterung an den Seiten des Schwingungskörpers 12 in unterschiedlicher Ausprägung auszuführen. Hierdurch kann beispielsweise durch Entfernen von Stegen auf der einen Seite, nämlich der mit geringerem Grad an Verbreiterung, eine gröbere Einstellung der Resonanzfrequenz und durch Entfernen von Stegen auf der anderen Seite, nämlich der mit größerem Grad an Verbreiterung, eine feinere Einstellung der Resonanzfrequenz erzielt werden. Ebenso kann der Abstand und die Breite der Stege unterschiedlich sein.

Nachfolgend wird bezug nehmend auf Fig. 5a-5c ein Ausführungsbeispiel für ein mikromechanisches Bauelement beschrieben, bei dem eine Elektrodenkonfiguration vorgesehen ist, die die beiden Elektrodenkonfigurationen gemäß Fig. 2a und 2b kombiniert und somit zur Änderung der Resonanzfrequenz fähig ist, und die zudem zur Erregung einer Schwingung des Schwingungssystems sowie zur Erfassung der Diskrepanz zwischen Resonanzfrequenz und der Erregerfrequenz und somit zur Regelung der Resonanzfrequenz auf die Erregerfrequenz in der Lage ist, so daß die Amplitude der Schwingung des Schwingungssystems maximiert werden kann.

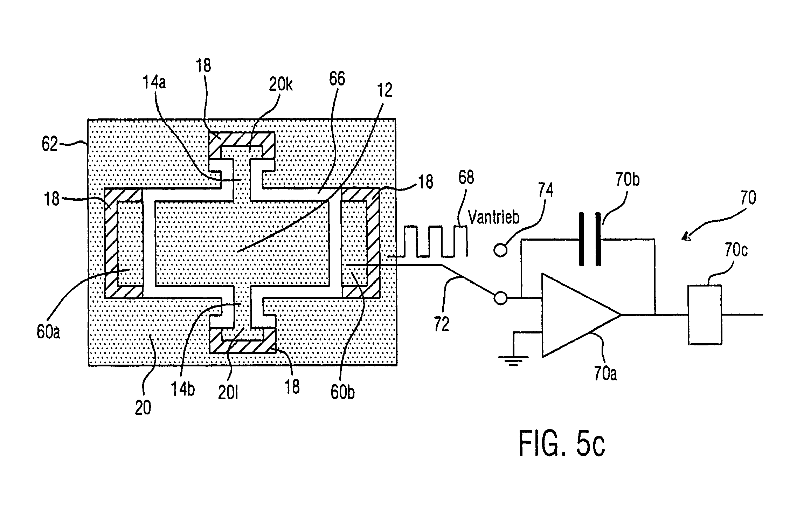

Anhand von Fig. 5a und 5b wird zunächst der Aufbau des mikromechanischen Bauelements beschrieben. Fig. 5a zeigt eine Draufsicht des mikromechanischen Bauelements, während Fig. 5b einen Querschnitt entlang der gestrichelten Linie A-A in Fig. 5a zeigt. Anhand von Fig. 5c , die ebenfalls eine Draufsicht des mikromechanischen Bauelements zeigt, wird anschließend die Funktionsweise desselben beschrieben, wie sie sich durch eine dort gezeigte Regelschaltung ergibt.

Hinsichtlich des groben mechanischen Aufbaus, d.h. der Einschränkung der Bewegungsfreiheit der beweglichen Elektrode auf eine Schwenkbewegung, und hinsichtlich des Schichtaufbaus aus Strukturierungsschicht 16, vergrabener Isolationssicht 18 und Substratrahmen 30 entspricht das mikromechanische Bauelement dem Ausführungsbeispiel von Fig. 1. Bereiche 60a bzw. 60b des Bauelementrahmens 20 in der Strukturierungsschicht 16 sind von einem Rest 62 des Bauelementrahmens 20 und darüber hinaus auch zu der Aufhängung 14a, 14b und dem Schwingungskörper 12, die alle in einer Schicht gebildet sind, elektrisch isoliert. Die Anker 20k bzw. 201 der Aufhängung 14a und 14b liegen auf der Isolationssicht 18 auf.

Die Bereiche 60a und 60b dienen als Erregungselektroden, sind elektrisch miteinander verbunden, so daß sich dieselben stets auf dem selben elektrischen Potential befinden, und sind den von der Schwingungsachse wegweisenden Enden des Schwingungskörpers 12 über einen Spalt 64a bzw. 64b gegenüberliegend angeordnet. Anders ausgedrückt liegen die Bereiche 60 und 60b dem Schwingungskörper 12 in seiner Ruhelage in gleichem Abstand gegenüber, und zwar an jeweils denjenigen Stellen, die bei einer Schwingung des Schwingungskörpers 12 die größten Wege zurücklegen, d.h. die von der Schwenkachse am weitesten entfernt liegenden Teile des Schwingungskörpers 12. Die Bereiche 60a und 60b werden im folgenden als Außenelektrode bezeichnet.

Der Rest 62 des Bauelementrahmens 20, der ebenfalls zu Aufhängung 14 und Schwingungsköper 12 isoliert ist, umgibt den Schwingungskörper 12 entlang dessen Umfanges ausgenommen derjeniger Stellen, an denen der Schwingungskörper aufgehängt ist. Insbesondere liegen sich der Rest 62 des Bauelementrahmens 20 und der Schwingungskörper entlang der longitudinalen Abschnitte des Schwingungskörpers 12 unmittelbar über einen Spalt und entlang der Abschnitte des Umfanges, die von der Schwingungsachse am weitesten entfernt sind, mit den Erregungselektroden 60a und 60b dazwischen gegenüber. Der Rest 62 des Bauelementrahmens 20 dient als Gegenelektrode im Sinne des Ausführungsbeispiels von Fig. 2a und wird im folgenden als Tune- bzw. Abstimmungselektrode bezeichnet.

Unterhalb des Schichtaufbaus aus Strukturierungsschicht 16, in der Schwingungskörper 12, Aufhängung 14 und Bauelementrahmen 20 gebildet sind, vergrabener Isolationsschicht 18 und Substratrahmen 30 des Schwingungskörpers 12 ist eine leitfähige Substratplatte 66 angeordnet, die als Gegenelektrode im Sinne des Ausführungsbeispiels von Fig. 2b dient und durch die Isolationssicht 18 von allen anderen Elektroden getrennt ist. Die Substratplatte 66 ist derart angebracht, um dem Schwingungskörper 12 in der Ruhelage in einem gleichmäßigen Abstand parallel gegenüberzuliegen, und wird im folgenden ebenfalls als Tuneelektrode bezeichnet.

Nachdem im Vorhergehenden der Aufbau des mikromechanischen Bauelements von Fig. 5a-5c beschrieben worden ist, wird im folgenden dessen Ansteuerung und Funktionsweise beschrieben, wenn dasselbe beispielsweise als Mikroscanner zur Ablenkung eines modulierten Lichtstrahls verwendet wird. Die Aufgabe des Mikroscanners besteht darin, eine Schwingungsbewegung des Spiegels 12 mit einer konstanten Sollfrequenz und einer möglichst großen Amplitude zu erzeugen, um einen Lichtstrahl mit dieser Frequenz abzulenken.

Die Anregung des Spiegels 12 erfolgt in diesem Beispiel derart, daß zwischen Spiegel 12 und Außenelektrode 60a bzw. 60b eine periodische, rechteckförmige Spannung angelegt wird, die zwischen einer ersten und einer zweiten Spannung hin- und herwechselt, wie sie in Fig. 5c mit 68 angedeutet ist, und wie es später noch detaillierter erörtert wird. Aufgrund von minimalen fertigungsbedingten Asymmetrien wird bei Anliegen einer Spannung geeigneter Frequenz eine periodische Auslenkung des beweglichen Spiegels 12 erreicht. Da die Kapazität, die sich zwischen Spiegel 12 und Außenelektrode 60a bzw. 60b ergibt, maximal in der Ruhelage des Spiegels 12 ist, ergibt sich im ausgelenkten Zustand bei anliegender Spannung ein beschleunigendes elektrostatisches Drehmoment. Die maximale Amplitude der Spiegelschwingung wird erreicht, wenn die Spannung genau im Nulldurchgang der Schwingung abgeschaltet wird. Ansonsten wird dem Feder-Masse-Schwingungssystem entweder zu wenig Energie eingekoppelt, da die Spannung vor dem Erreichen des Nulldurchgangs abgeschaltet wird, oder es wird durch ein bremsendes elektrostatisches Drehmoment Energie entzogen, da die Spannung erst nach dem Passieren des Nulldurchgangs abgeschaltet wird. Diese Tatsache ist wichtig für die im folgende beschriebene Vorgehensweise zur Regelung der Schwingungsamplitude.

Mit Hilfe der Tuneelektroden 62 bzw. 66 können basierend auf den Überlegungen, wie sie bezugnehmend auf Fig. 2a und 2b erörtert wurden, Schwankungen der Resonanzfrequenz ausgeglichen werden. Dazu wird, zur Erhöhung der Resonanzfrequenz, zwischen die Tuneelektrode 62 und den Spiegel 12 oder, zur Verringerung der Resonanzfrequenz, zwischen die Tuneelektrode 66 und den Spiegel 12 eine Spannung geeigneter Höher angelegt. Dieser Vorgang wird durch eine Tuneelektrodenansteuerung (nicht gezeigt) durchgeführt.

Wie oben bereits erwähnt, ist es das Ziel einer in Fig. 5c gezeigten und im folgenden bezugnehmend auf diese Figur beschriebenen Regelungsschaltung, daß der Scannerspiegel derart geregelt wird, daß bei fester, von außen vorgegebener Anregungsfrequenz, eine maximale Schwingungsamplitude des Spiegels 12 durch eine Anpassung der Resonanzfrequenz mittels der Tuneelektrodenansteuerung erzielt wird. Insbesondere überwacht die Regelungsschaltung die Bewegung des Spiegels 12 und erzeugt basierend auf der Überwachung Rückkopplungssteuersignale für die Tuneelektrodensteuerung, die auf diese Steuersignale anspricht, um die Resonanzfrequenz des Schwingungssystems und damit die momentane Schwingungsamplitude zu ändern.

Eine exemplarische Regelschaltung hierfür ist in Fig. 5c allgemein mit 70 angezeigt. Die Regelschaltung 70 besteht aus einem Ladungsverstärker zum Erfassen der Ladung an der Außenelektrode 60a bzw. 60b bestehend aus einer Parallelschaltung aus Operationsverstärker 70a und Kapazität 70b und einer Steuereinrichtung 70c. Ein erster Eingang der Verstärkers ist mit einer ersten Elektrode der Kapazität 70b und über einen Schalter 72 mit der Außenelektrode 60a bzw. 60b elektrisch verbunden. Der Ausgang des Operationsverstärkers 70a ist mit der anderen Elektrode der Kapazität 70b und einem Eingang der Steuereinrichtung 70c verbunden. Ein Ausgang der Steuereinrichtung 70c bildet den Ausgang zum Ausgeben des Steuersignals der Regelschaltung 70 an die Tuneelektrodensteuerung. Ein anderer Eingang des Operationsverstärkers 70a ist auf Masse geschaltet.

Der Schalter 72 ist, wie erwähnt, mit einem ersten Anschluß zwischen Regelschaltung 72 und Außenelektrode 60a und 60b geschaltet. Ein weitere Anschluß des Schalters 72 ist mit einem Spannungsanschluß 74 verbunden, an dem das Potential V_{antrieb} anliegt. Der Schalter 72 sorgt für den im vorhergehenden beschriebenen Antrieb des Spiegels 12, indem sie in einer von außen fest vorgegebenen Erregerfrequenz zwischen den beiden Anschlüssen hin- und herschaltet und damit zwischen Spiegel 12, der ebenfalls auf das Potential V_{antrieb} vorgespannt ist, und Außenelektroden 60a und 60b eine Erregungsspannung eines rechteckförmigen Verlaufs und mit der fest vorgegebenen Frequenz erzeugt. Genauer ausgedrückt wird durch den Schalter 72 die Außenelektrode 60a bzw. 60b zwischen den Operationsverstärker 70a (virtuelle Masse) und Vantrieb hin- und hergeschaltet.

In den Zeitpunkten, da der Schalter 72 die Regelschaltung 70 mit der Außenelektrode 60a bzw. 60b verbindet, wird durch die Regelschaltung 70 die Ladung bestimmt, die sich auf der Außenelektrode 60a bzw. 60b befindet. Der zeitliche Verlauf der Ladung auf der Außenelektrode 60a bzw. 60b hängt von der Kapazität zwischen Spiegel 12 einerseits und Außenelektrode 60a bzw. 60b andererseits ab. Während also in der Phase, da die Regelschaltung 70 mit der Außenelektrode 60a bzw. 60b gekoppelt ist, die Spannung V_{antrieb} den Spiegel 12 auf die Ruhelage hin beschleunigt, kann die Ladung zwischen Spiegel 12 und Außenelektrode 60a bzw. 60b durch die Schaltung 70 bestimmt werden, indem der Operationsverstärker 70a mit der Kapazität 70b in der Gegenkopplungsschleife den zu oder von der Elektrode 60a bzw. 60b zu- bzw. abfließenden Strom von dem Zeitpunkt an, da der Schalter 72 den Eingang des Ladungsverstärkers mit der Außenelektrode 60a bzw. 60b zuletzt verband, integriert und in ein Spannungssignal umwandelt und dieses Ergebnis an die Steuereinrichtung 70c ausgibt. Anders ausgedrückt gibt das Ausgangssignal des Operationsverstärkers 70a die Integration über den Ladungszu- und -abfluß zu bzw. von der Elektrode 60a bzw. 60b seit dem letzten Umschalten des Schalters 72 an, woraus insbesondere auf die Ladung zum Zeitpunkt des letzten Umschaltens rückgeschlossen werden kann.

Wird durch den Schalter 72 die Spannung zwischen Spiegel 12 und Außenelektrode 60a bzw. 60b aufgrund der extern vorgegebenen Frequenz für den Schalter 72 abgeschaltet, bevor der Spiegel 12 die Ruhelage erreicht, weil die Frequenz des Spiegels 12 zu niedrig ist, so ist der zuletzt vom Ladungsverstärker 70a,70b ermittelte Wert geringer als der tatsächlich maximal mögliche Wert der Ladung. Wird die Spannung aufgrund der extern vorgegebenen Frequenz abgeschaltet, nachdem der Spiegel 12 die Ruhelage erreicht hat, da dessen Frequenz zu hoch ist, so ist der zuletzt ermittelte Wert der Ladung zwar ebenfalls kleiner als das erreichbare Ladungsmaximum, das Ladungsmaximum wurde aber passiert und damit durch den Ladungsverstärker 70a, 70b detektiert und insbesondere durch die das Ausgangssignal des Ladungsverstärkers 70a, 70b überwachende Steuereinrichtung 70c erfaßbar.

Im ersten Fall, da also die Steuereinrichtung 70c eine zu niedrige Spiegelschwingungsfrequenz erfaßt, muß dieselbe mittels der Steuersignale an die Tuneelektrodensteuerung dafür sorgen, daß mindestens ein Potential der beiden Tuneelektroden 62 bzw. 66 bzw. die Spannung zwischen denselben und dem Spiegel 12 so geändert wird, daß die Resonanzfrequenz des Spiegel 12 virtuelle erhöht wird. Im zweiten Fall muß die Steuereinrichtung 70c mindestens ein Potential der beiden Tuneelektroden 62 bzw. 66 so ändern, daß die Resonanzfrequenz des Spiegels 12 virtuell verringert wird, was auf die bezugnehmend auf Fig. 2a und 2b beschieben Weise durchgeführt wird. Liegt Tuneelektrode 62 auf dem Potential V_{T1}, und Tuneelektrode 66 auf dem Potential V_{T2}, so ergeben sich eine Tunespannung V_{T1} - V_{antrieb} zwischen Spiegel 12 und Elektrode 62 und eine Tunespannung V_{T2} - V_{antrieb} zwischen Spiegel 12 und Elektrode 66. Die rein mechanisch determinierte Resonanzfrequenz ergibt sich für den Fall V_{T2} = V_{T1}, = V_{antrieb}. Auf der Grundlage dieser Regelung durch die Steuereinrichtung 70c wird die Resonanzfrequenz des Schwingungssystems auf die von außen vorgegebene Erregungsfrequenz des Schalters 72 geregelt, so daß aufgrund der Resonanzerhöhung die Schwingungsamplitude bei gegebenem Erregungssignal maximal ist. Die Schwingungsamplitude kann im eingeregelten Fall gegebenenfalls über den Betrag von V_{antrieb} variiert werden.

Noch einmal zusammenfassend ausgedrückt wird bei der Regelung der Schwingungsamplitude nach dem im vorhergehenden beschriebenen Ausführungsbeispiel folgendermaßen vorgegangen. Der Schalter 72 sorgt durch ein An- und Ausschalten einer anziehenden Spannung zwischen Spiegel 12 und Außenelektrode 60a und 60b, quasi in Erregungsphasen mit anziehender Kraft und Freischwingungsphasen ohne anziehende Kraft, mit einer festen von außen vorgegebenen Erregerfrequenz für eine Schwingung des Schwingungssystems. Um die Schwingungsamplitude des Schwingungssystems zu maximieren, regelt die Regelschaltung 70 die Resonanzfrequenz des Schwingungssystems auf die Erregerfrequenz, da dann die Resonanzüberhöhung am höchsten ist. Dies geschieht, indem die Regelschaltung 70 die Kapazität bzw. die Ladung des aus Spiegel 12 einerseits und Außenelektrode 60a und 60b andererseits bestehenden Kondensators überwacht und daraus bestimmt, ob die Schwingung des Schwingungssystems der Erregerfrequenz vorauseilt oder hintereilt. Damit die beiden Frequenzen gleich sind, müßte bei Wechsel von Freischwingungsphase zu Erregungsphase und umgekehrt die Kapazität bzw. die Ladung zwischen Spiegel 12 und Elektrode 60a bzw. 60b auch am größten sein, da dieselben dann einander am nächsten wären. Eine Diskrepanz der beiden Schwingungsfrequenzen rührt aus einer Fehlanpassung der Resonanzfrequenz des Schwingungsfrequenz her, da sich während der Freischwingungsphasen das Schwingungssystem zur Resonanzfrequenz hin ändert, die eben entweder kleiner oder größer als die Erregerfrequenz ist. Die Regelschaltung 70 gibt dann entsprechende Regelsignale an Einrichtungen aus, die demnach die Tunespannungen zwischen Spiegel und Tuneelektrode 66 einerseits und zwischen Spiegel und Tuneelektrode 62 andererseits ändern. Diese Änderungen ändern, wie bezüglich Fig. 2a und 2b beschrieben, wiederum die Resonanzfrequenz usw...

Alternativ zu dem vorhergehenden Ausführungsbeispiel einer Regelung der Resonanzfrequenz des Schwingungssystems könnte die Anregung der Schwingung auch über die Elektroden 60a bzw. 60b und die Bestimmung der Ladung über die Elektrode 62 erfolgen, wobei der Spiegel 12 auf Potential V_{antrieb} geschaltet und Elektrode 60a bzw. 60b zwischen Masse und V_{antrieb} hin- und hergeschalten wird. Dann kann die Anpassung der Resonanzfrequenz auch erfolgen, indem auf die Rechteckspannung zwischen Spiegel 12 und Außenelektrode 62 ein Offset bzw. eine Versatzspannung gegeben wird, d.h. anstatt das Potential der Außenelektrode 60a bzw. 60b zwischen Masse und V_{antrieb} hin- und herzuschalten und das Potential des Spiegels auf dem Potential V_{antrieb} zu halten, wird die Elektrode 60a bzw. 60b zwischen einem Potential -V_{Tune} und V_{antrieb} - V_{Tune} hin- und hergeschalten, so daß sich eine Rechteckspannung ergibt, die zwischen V_{antrieb} + V_{Tune} und V_{Tune} hin- und herwechselt. Der Offset bewirkt ebenfalls ein zusätzliches konstantes elektrostatisches Drehmoment, welches die Resonanzfrequenz erhöht, entsprechend dem Ausführungsbeispiel von Fig. 2a. Zur Beibehaltung der gewünschten Schwingungsamplitude kann es erforderlich sein, Vantrieb bei Änderung von V_{Tune} anzupassen.

Bezugnehmend auf den Aufbau des mikromechanischen Bauelements von Fig. 5a-5c wird darauf hingewiesen, daß die Tuneelektrode 62 gegebenenfalls durch einen Isolationsgraben von einem Chiprand eines Chips, in welchen das mikromechanische Bauelement integriert ist, elektrisch isoliert sein kann. Zudem könnte die Tuneelektrode 66 gegebenenfalls geteilt realisiert sein, so daß zwei Elektroden links und rechts der Torsionsachse unterhalb de Spiegels entstünden. Ferner wird darauf hingewiesen, daß die Elektrodenbereiche wie auch schon bei den vorangegangenen Ausführungsbeispielen entweder durch leitfähige Abschnitte der Schicht 16, die durch Isolationsgräben getrennt sind, oder durch entsprechende leitfähige Beschichtungsbereiche gebildet sein können.

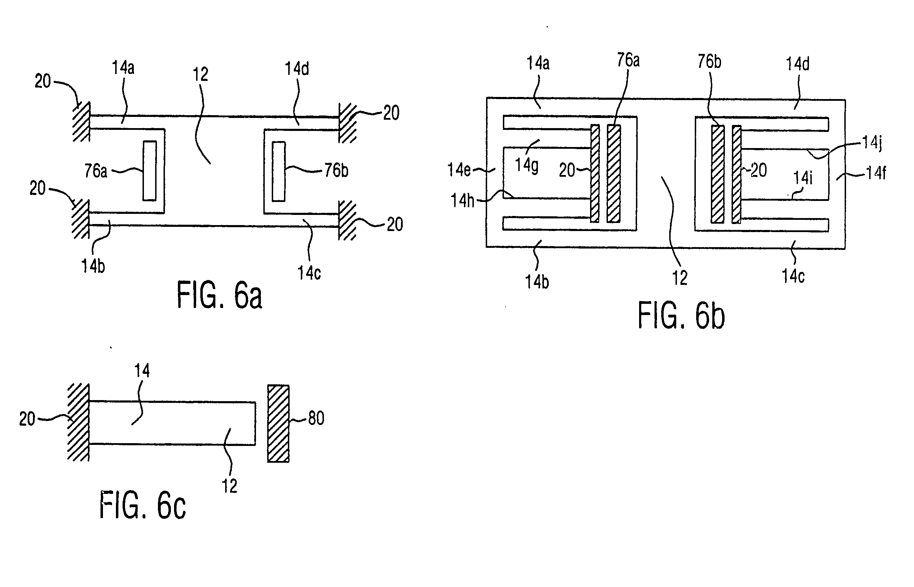

Bezug nehmend auf die vorhergehende Beschreibung wird darauf hingewiesen, daß sich die vorhergehende Beschreibung lediglich der besseren Verständlichkeit halber auf Ausführungsbeispiele beschränkte, bei denen der Schwingungskörper derart aufgehängt war, daß er nur eine Verkippung ausführen konnte bzw. eine Schwenkbewegung bzw. Schwenkschwingung ausführte. Die vorliegende Erfindung ist jedoch bei jedwedem mikromechanischen Bauelement anwendbar, welches ein Schwingungssystem aus Schwingungskörper und elastischer Aufhängung aufweist. Fig. 6a - 6c zeigen weitere Ausführungsbeispiele für solche mikromechanischen Bauelemente.

Fig. 6a zeigt einen Schwingungskörper 12, der derart aufgehängt ist, daß er sich translatorisch vor- und zurückbewegen kann, und zwar bezüglich der Blickrichtung von Fig. 6a aus der Bildebene heraus bzw. in dieselbe hinein. Die Aufhängung besteht aus elastischen Biegefedern bzw. Biegebalken 14a, 14b, 14c und 14d, die an den Ecken des rechtekkig gebildeten Schwingungskörpers 12 fußend sich paarweise in gegenüberliegende Richtungen erstrecken, um an Ankerpunkten eines Bauelementrahmens 20 befestigt zu sein.

Wie bei den Ausführungsbeispielen der Fig. 1, 3, 4 und 5 könnten auch bei diesem Ausführungsbeispiel Schwingungskörper 12, Aufhängung 14 und Bauelement 23 in einer Ebene gebildet sein. Es könnten zudem durchtrennbare Stege vorgesehen sein, die die gleichlangen Biegebalken 14a-14d an verschiedenen Fixierungsstellen entlang deren Länge fixieren, um ihre effektive Länge im nichtdurchtrennten Zustand zu verkürzen und die Federsteifigkeit zu erhöhen und im durchtrennten Zustand die effektive Länge zu vergrößern und die Federsteifigkeit zu verringern.

Wie bei dem Ausführungsbeispiel von Fig. 2a könnten Gegenelektroden 76a und 76b entlang des Rands des Schwingungskörpers 12 vorgesehen sein, um durch eine Spannungsdifferenz zu demselben die Federkonstante des Feder-Masse-Systems virtuell zu erhöhen. Wie bei dem Ausführungsbeispiel von Fig. 2b könnten Gegenelektroden vorgesehen sein, um durch eine Spannungsdifferenz zu demselben die Federkonstante des Feder-Masse-Systems virtuell zu verringern, wie z.B. eine Gegenelektrode oberhalb und eine weitere Gegenelektrode unterhalb des Schwingungskörpers 12, beide auf demselben elektrischen Potential.

Fig. 6b zeigt einen Aufbau eines mikromechanischen Bauelements, dessen Aufhängung ebenfalls eine translatorische Vor- und Zurückbewegung eines Schwingungskörpers 12 ermöglicht. Für einen geringeren lateralen Platzverbrauch sind die Biegefedern der Aufhängung jedoch nicht außen an Ankerpunkten eines Bauelementrahmens befestigt, sondern sind durch mehrere Biegefedersegmente gebildet, die zusammen eine U-Form bilden. Erste Biegefedersegmente 14a erstrecken sich von den Ecken des Schwingungskörpers 12 jeweils paarweise in entgegengesetzte Richtungen zu einem ungehalterten Querbiegebaken 14e bzw. 14f. Von diesen Querbiegebalken 14e bzw. 14f ausgehend erstrecken sich weiter innen liegende Biegefedern 14g, 14h bzw. 14i und 14j jeweils nach innen in Richtung Schwingungskörper 12, um an Ankerpunkten 20 befestigt zu sein. Wiederum sind exemplarisch dem Schwingungskörper 12 entlang des Umfangs gegenüberliegenden Gegenelektroden 76a und 76b gezeigt, die als Gegenelektroden des Typs nach Fig. 2a dienen können. Gegenelektroden nach Fig. 2b könnten oberhalb und unterhalb des Schwingungskörpers 12 vorgesehen sein. Die Länge der Biegefeder verlängert sich im Vergleich zu dem Aufbau von Fig. 6a jeweils um die Länge der Biegefedern 14g, 14h, 14i und 14j.

In Fig. 6c ist ein mikromechanisches Bauelement gezeigt, bei dem Schwingungskörper 12 und Aufhängung 14 nicht nur einstückig sondern auch übergangslos ineinander übergehend als einseitig eingespannter Ausleger gebildet sind, der an einem Anker 20 befestigt ist. Dem freien Ende des Auslegers, der dem Schwingungskörper 12 entspricht, gegenüberliegend ist exemplarisch eine Gegenelektrode 80 angeordnet, die derselben Funktion wie die Gegenelektroden gemäß dem Ausführungsbeispiel von Fig. 2a dienen könnte. Gegenelektroden nach Fig. 2b könnten oberhalb und unterhalb des Schwingungskörpers 12 vorgesehen sein.

Es wird darauf hingewiesen, daß, obwohl im Vorhergehenden Bezug nehmend auf die Fig. 1 - 5 lediglich Ausführungsbeispiele beschrieben wurden, die sowohl eine diskrete Einstellbarkeit der Resonanzfrequenz des Schwingungssystems durch irreversible Durchtrennung von Stegen sowie eine Einstellbarkeit durch Definieren eines elektrostatischen Energieminimums bzw. Energiemaximums an der Ruhelage des Schwingungskörpers ermöglichten, die vorliegende Erfindung nicht auf diese Ausführungsbeispiele beschränkt ist. Die Einstellbarkeit der Resonanzfrequenz durch Stegdurchtrennung könnte weggelassen werden. Dennoch ermöglicht gerade die Kombination dieser beiden Einstellmöglichkeiten einen nicht zu vernachlässigenden Vorteil, da durch die durch die Stegdurchtrennung gelieferte Vorabeinstellbarkeit auch diejenigen mikromechanischen Bauelemente verwertet werden können, die unmittelbar nach der Herstellung eine Resonanzfrequenz besitzen, die eigentlich außerhalb des durch das erfindungsgemäße elektrostatische Einstellbarkeitsprinzip bereitgestellten Frequenzregelungsbereiches liegt. Dies ist insbesondere deshalb vorteilhaft, da im allgemeinen der Regelungsbereich der Resonanzfrequenz durch die elektrostatische Definition eines Potentialminimums bzw. -maximums im Vergleich zu den Fertigungsschwankungen gering ist, so daß ohne die Einstellbarkeit durch Stegdurchtrennung eine große Anzahl von hergestellten Bauelementen, die eine zu große Resonanzfrequenzabweichung besäßen, nicht zur Ausbeute beitragen könnten. Diese kombinierte Einstell- und Regelbarkeit ist folglich in der Lage, sowohl Abweichungen als auch Schwankungen der Resonanzfrequenz auszugleichen, wodurch die Ausbeute bei der Fertigung signifikant erhöht wird. Zudem ist ein und dasselbe Bauelement für verwandte Anwendungen verwendbar, wenn die Anwendungen sich lediglich durch die gewünschte Resonanzfrequenz unterscheidet, da sich diese Bauelemente schließlich lediglich durch die verschiedene Anzahl durchtrennter Stege unterscheiden. Folglich können diese mikromechanischen Bauelemente bis auf die Stegdurchtrennung auf dieselbe Weise und damit kostengünstig hergestellt werden. Die Entfernung der Stege kann nicht nur, wie im vorhergehenden beschrieben, durch Stromfluß, Ionenstrahlen oder Laserstrahlen erfolgen, sondern ferner durch Elektronenstrahlen oder elektromagnetische Strahlung. Ferner kann der Schwingungskörper auch, anders als in den Figuren 1, 3, 4, 5, 6a und 6b gezeigt, nichtsymmetrisch aufgehängt sein. Allgemein kann der Schwingungskörper derart aufgehängt sein, daß eine Verkippung, Translation, eine Rotation oder jedwede komplexe Bewegung, die sich aus Rotation, Translation und Verkippung in beliebiger Richtung und Art zusammensetzen kann, ausführen kann. Anstatt die Gegenelektroden nach dem Ausführungsbeispiel von Fig. 2b unterhalb des Schwingungskörpers anzuordnen, könnten dieselben freilich auch oberhalb angeordnet sein.

Ferner wird darauf hingewiesen, daß bei Verwendung zweier unabhängiger Spannungsquellen auch eine elektrostatische Abstoßung zwischen fester Gegenelektrode einerseits und Schwingungskörper andererseits erzielt werden könnte, indem auf Schwingungskörper einerseits und fester Elektrode andererseits gleichnamige Ladungen aufgebracht würden, so daß bei den im Vorhergehenden beschriebenen Ausführungsbeispielen von Fig. 2a und 2b auch gegenteilige Effekte, d.h. anstatt einer virtuellen Federkonstantenerhöhung eine Federkonstantenreduzierung und umgekehrt, erzielt werden könnten, was jedoch aufgrund des technischen Aufwands weniger bevorzugt ist.

Im Bezug auf das Ausführungsbeispiel von Fig. 1 wird darauf hingewiesen, daß die Isolationsgräben nicht geschlossen sein müssen, sondern auch offen sein können. Zudem können die in der Halbleiterschicht gebildeten Strukturen wie Feder, Schwingungskörper und Rahmen nicht nur gleiche Dicken aufweisen, sondern ferner unterschiedliche Dicken aufweisen, wie z.B. mittels eines geeigneten Ätzverfahrens zur Dünnung spezieller Stellen.

Ferner wird darauf hingewiesen, daß, obwohl im Vorhergehenden Bezug nehmend auf Fig. 5 lediglich ein nach dem elektrostatischen Prinzip arbeitendes Erregersystem zur Erregung der Schwingung des Schwingungssystems beschrieben worden ist, ferner auch magnetische Kräfte, piezoelektrische Kräfte oder Schall zur Schwingungsanregung verwendet werden können.

Ferner wird darauf hingewiesen, daß, obwohl im Vorhergehenden lediglich auf einen Mikrospiegel als eine potentielle Anwendung der vorliegenden Erfindung Bezug genommen wurde, die vorliegende Erfindung auch bei anderen mikromechanischen Bauelementen mit anpaßbarer Schwingungsfrequenz eingesetzt werden kann, sowie insbesondere auch bei Sensoren. Die Erfindung ist insbesondere vorteilhaft bei Anwendungen, bei denen das Schwingungssystem eines mikromechanischen Bauelements in seiner Resonanzfrequenz betrieben wird oder in der Nähe seiner Resonanzfrequenz, so daß die Erhöhung der Schwingungsamplitude durch den Resonanzeffekt ausgenutzt wird.

Zu dem Ausführungsbeispiel der Fig. 2a und 2b wird darauf hingewiesen, daß lediglich eine Gegenelektrode notwendig ist. Im Fall von Fig. 2b könnten die beiden Gegenelektroden 40a und 40b zu einer gemeinsamen, sich über beide erstrekkende, ersetzt werden.

## Patentansprüche

1. Mikromechanisches Bauelement mit folgenden Merkmalen:
einem Schwingungssystem, das
einen Schwingungskörper (12), und eine elastische Aufhängung (14) aufweist, die beide in einer Ebene gebildet sind, wobei der Schwingungskörper (12) durch die elastische Aufhängung (14) derart schwingfähig aufgehängt ist, dass sich ein Teil des Schwingungskörpers (12) aus der Ebene herausbewegt; und
eine Einrichtung zum Einstellen einer Resonanzfrequenz des Schwingungssystems durch Anlegen einer konstanten Spannungsdifferenz zwischen zumindest einem Teil des Schwingungskörpers (12) und zumindest einer stationären Elektrode (20a, 20b; 40a, 40b), die ebenfalls in der Ebene gebildet ist.

2. Mikromechanisches Bauelement gemäß Anspruch 1, bei dem die stationäre Elektrode (20a, 20b) derart angeordnet ist, daß sie bei Auslenkung des Schwingungskörpers (12) aus seiner Ruhelage eine elektrostatische Gegenkraft in Richtung der Ruhelage bewirkt.

3. Mikromechanisches Bauelement gemäß Anspruch 1, die ferner eine weitere stationäre Elektrode (40a, 40b) aufweist, die derart angeordnet ist, daß sie bei Auslenkung des Schwingungskörpers (12) aus seiner Ruhelage eine elektrostatische Kraft in Richtung weg von der Ruhelage bewirkt.

4. Mikromechanisches Bauelement gemäß einem der Ansprüche 1 bis 3, das ferner folgendes Merkmal aufweist:
einen durchtrennbaren Steg (22) zum optionalen Fixieren der elastischen Aufhängung (14) an einem Fixierungspunkt, um in einem nichtdurchtrennten Zustand einen Verformungsbereich der elastischen Aufhängung (14), in welchem sich die elastische Aufhängung (14) bei einer Schwingung des Schwingungskörpers elastisch verformt, einzuschränken und in einem durchtrennten Zustand zu vergrößern.

5. Mikromechanisches Bauelement gemäß Anspruch 4, das mehrere durchtrennbare Stege zum Fixieren der elastischen Aufhängung (14) an einem jeweiligen Fixierungspunkt in einem nichtdurchtrennten Zustand aufweist.

6. Mikromechanisches Bauelement gemäß Anspruch 4 oder 5, bei dem die elastische Aufhängung (14) einen ersten Teil (14a1) mit einem kleineren Querschnitt und einen zweiten Teil (14a2) mit einem größeren Querschnitt aufweist.

7. Mikromechanisches Bauelement gemäß Anspruch 6, bei dem in der Ebene (16) ferner ein Rahmen (20) mit einem Anker (20k, 201), an dem die elastische Aufhängung (14) befestigt ist, und ein Steg (22) gebildet sind, der sich zwischen einem Fixierungspunkt der elastischen Aufhängung (14) und dem Rahmen (20) erstreckt und entweder durchtrennt oder nicht durchtrennt ist.

8. Mikromechanisches Bauelement gemäß Anspruch 6 oder 7, bei dem der Schwingungskörper, die elastische Aufhängung und die stationäre Elektrode in einer Schicht gebildet sind, die sich in der Ebene erstreckt, und die statische Elektrode (20a, 20b; 60a, 60b) über einen Spalt in der Schicht (16) demjenigen Teil des Umfangs des Schwingungskörpers (12) gegenüberliegt, der bei einer Schwingung des Schwingungssystems die größte Auslenkung erfährt.

9. Mikromechanisches Bauelement gemäß einem der Ansprüche 1 bis 7 mit einer ersten weiteren stationären Elektrode (40a), die derart angeordnet ist, daß sie sich bei einer Auslenkung des Schwingungskörpers (12) in einer ersten Auslenkungsrichtung aus seiner Ruhelage dem zumindest einen Teil des Schwingungskörpers (12) nähert, und bei Auslenkung des Schwingungskörpers (12) in einer zweiten Auslenkungsrichtung aus seiner Ruhelage von dem zumindest einen Teil des Schwingungskörpers (12) entfernt, und einer zweiten weiteren statischen Elektrode (40b), die derart angeordnet ist, daß sie sich bei einer Auslenkung des Schwingungskörpers (12) in der ersten Auslenkungsrichtung aus der Ruhelage von dem zumindest einen Teil des Schwingungskörpers (12) entfernt, und bei einer Auslenkung des Schwingungskörpers (12) in der zweiten Auslenkungsrichtung aus der Ruhelage dem zumindest einen Teil des Schwingungskörpers (12) nähert.

10. Mikromechanisches Bauelement gemäß einem der Ansprüche 1 bis 9, bei dem in einer sich in der Ebene erstreckenden Schicht (16) eine erste Torsionsfeder (14a), eine zweite Torsionsfeder (14b) und der Schwingungskörper (12) gebildet sind, wobei die erste und die zweite Torsionsfeder (14a, 14b) eine Schwenkachse für den Schwingungskörper (12) definieren, die den Schwingungskörper in einen ersten und einen zweiten Teil teilt, die sich bei einer Auslenkung des Schwingungskörpers (12) aus einer Ruhelage in verschiedene Richtungen aus der Ebene herausbewegen, wobei eine erste und die zweite weitere statische Elektrode (40a, 40b) entweder unterhalb oder oberhalb des Schwingungskörpers (12) angeordnet sind und die erste weitere statische Elektrode (40a) einem der beiden Teile und die zweite statische weitere Elektrode (40b) dem anderen der beiden Teile des Schwingungskörpers (12) gegenüberliegt.

11. Mikromechanisches Bauelement gemäß einem der Ansprüche 1 bis 10, bei dem die elastische Aufhängung (14) als Torsionsfeder wirkt.

12. Mikromechanisches Bauelement gemäß einem der Ansprüche 1 bis 11, bei dem die elastische Aufhängung (14) als einseitig eingespannte Biegefeder wirkt.

13. Mikromechanisches Bauelement gemäß einem der Ansprüche 1 bis 11, bei dem die elastische Aufhängung (14) derart angeordnet ist, um eine Schwingungsbewegung des Schwingungskörpers (12) auf eine Verkippungsbewegung um eine Schwenkachse einzuschränken.

14. Mikromechanisches Bauelement gemäß einem der Ansprüche 1 bis 9 oder 12, bei dem die elastische Aufhängung (14) derart angeordnet ist, um eine Schwingungsbewegung des Schwingungskörpers 812) auf eine Translationsbewegung entlang einer Schwingungsachse einzuschränken.

15. Verfahren zum Betreiben eines mikromechanischen Bauelements mit einem Schwingungssystem, das einen Schwingungskörper und eine elastische Aufhängung aufweist, die beide in einer Ebene gebildet sind, wobei der Schwingungskörper durch die elastische Aufhängung (14) derart schwingfähig aufgehängt ist, dass sich ein Teil des Schwingungskörpers (12) aus der Ebene herausbewegt, wobei das Verfahren folgenden Schritt umfaßt:
Einstellen einer Resonanzfrequenz des Schwingungssystems durch Anlegen einer konstanten Spannungsdifferenz zwischen zumindest einem Teil des Schwingungskörpers und zumindest einer stationären Elektrode, die ebenfalls in der Ebene gebildet ist.

## Claims

1. Micromechanical device comprising:
a vibrating system comprising:
a vibrating body (12) and an elastic suspension (14), both being formed in one plane, wherein the vibrating body (12) is vibratably suspended by the elastic suspension (14) such that part of the vibrating body (12) moves out the plane; and
means for adjusting a resonant frequency of the vibrating system by applying a constant voltage difference between at least one part of the vibrating body (12) and at least one stationary electrode (20a, 20b; 40a, 40b) also formed in the plane.

2. Micromechanical device according to claim 1, wherein the stationary electrode (20a, 20b) is arranged such that it causes an electrostatic counter-force in a direction of the rest position when the vibrating body (12) is deflected from its rest position.

3. Micromechanical device according to claim 1, further comprising another stationary electrode (40a, 40b) that is arranged such that it causes an electrostatic force in a direction away from the rest position when the vibrating body (12) is deflected from its rest position.

4. Micromechanical device according to one of claims 1 to 3, further comprising:
a rib (22) which may be cut through for optionally fixing the elastic suspension (14) at a fixing point to limit a deformation range of the elastic suspension (14) in which the elastic suspension (14) deforms elastically when the vibrating body vibrates in a non-cut-through state and to increase same in a cut-through state.

5. Micromechanical device according to claim 4, comprising several ribs which may be cut through for fixing the elastic suspension (14) at a respective fixing point in a non-cut-through state.

6. Micromechanical device according to claim 4 or 5, wherein the elastic suspension (14) comprises a first part (14a1) having a smaller cross-section and a second part (14a2) having a greater cross-section.

7. Micromechanical device according to claim 6, wherein a frame (20) having an anchor (20k, 201) where the elastic suspension (14) is fixed and a rib (22) extending between a fixing point of the elastic suspension (14) and the frame (20) and being either cut through or not cut through are also formed in the plane (16).

8. Micromechanical device according to claim 6 or 7, wherein the vibrating body, the elastic suspension and the stationary electrode are formed in one layer extending in the plane, wherein the static electrode (20a, 20b; 40a, 40b) is opposite to that part of the circumference of the vibrating body (12) across a slot in the layer 816) which is subject to the greatest deflection when the vibrating system vibrates.

9. Micromechanical device according to one of claims 1 to 7 having a first further stationary electrode (40a) which is arranged such that it approaches the at least one part of the vibrating body (12) with a deflection of the vibrating body (12) from its rest position in a first deflection direction, and withdraws from the at least one part of the vibrating body (12) with a deflection of the vibrating body (12) from its rest position in a second deflection direction, and a second further static electrode (40b) which is arranged such that it withdraws from the at least one part of the vibrating body (12) with a deflection of the vibrating body (12) from the rest position in the first deflection direction, and approaches the at least one part of the vibrating body (12) with a deflection of the vibrating body (12) from the rest position in the second deflection direction.

10. Micromechanical device according to one of claims 1 to 9, wherein a first torsion spring (14a), a second torsion spring (14b) and the vibrating body (12) are formed in one layer (16) extending in the plane, wherein the first and the second torsion springs (14a, 14b) define a pivot axis for the vibrating body (12) which divides the vibrating body into a first and a second part which move in different directions from the plane with a deflection of the vibrating body (12) from its rest position, wherein a first and the second further static electrode (40a, 40b) are arranged either below or above the vibrating body (12) and the first further static electrode (40a) is opposite to one of the two parts of the vibrating body (12) and the second further static electrode (40b) is opposite to the other one of the two parts.

11. Micromechanical device according to one of claims 1 to 10, wherein the elastic suspension (14) has the effect of a torsion spring.

12. Micromechanical device according to one of claims 1 to 11, wherein the elastic suspension (14) has the effect of a cantilevered bending spring.

13. Micromechanical device according to one of claims 1 to 11, wherein the elastic suspension (14) is arranged to limit a vibrating movement of the vibrating body (12) to a tilting movement around a pivot axis.

14. Micromechanical device according to one of claims 1 to 9 or 12, wherein the elastic suspension (14) is arranged to limit a vibrating movement of the vibrating body (12) to a translatory movement along a vibration axis.

15. Method of operating a micromechanical device having a vibrating system comprising a vibrating body and an elastic suspension, both being formed in one plane, wherein the vibrating body is vibratably suspended by the elastic suspension (14) such that part of the vibrating body (12) moves out of the plane, the method including the step of:
adjusting a resonant frequency of the vibrating system by applying a constant voltage difference between at least one part of the vibrating body and at least one stationary electrode also formed in the plane.

## Revendications

1. Composant micromécanique, aux caractéristiques suivantes:
un système oscillant qui
présente un corps oscillant (12) et une suspension élastique (14) formés tous deux dans un plan, le corps oscillant (12) étant suspendu de manière apte à osciller par la suspension élastique (14) de sorte qu'une partie du corps oscillant (12) se déplace hors du plan; et
un moyen destiné à régler une fréquence de résonance du système oscillant par application d'une différence de tension constante entre au moins une partie du corps oscillant (12) et au moins une électrode stationnaire (20a, 20b; 40a, 40b) qui est également formée dans le plan.

2. Composant micromécanique selon la revendication 1, dans lequel l'électrode stationnaire (20a, 20b) est disposée de sorte que, en cas de déviation du corps oscillant (12) hors de sa position de repos, elle entraîne une contre-force électrostatique en direction de la position de repos.

3. Composant micromécanique selon la revendication 1, présentant par ailleurs une autre électrode stationnaire (40a, 40b) qui est disposée de sorte que, en cas de déviation du corps oscillant (12) hors de sa position de repos, elle entraîne une contre-force électrostatique en direction opposée à la position de repos.

4. Composant micromécanique selon l'une des revendications 1 à 3, présentant par ailleurs la caractéristique suivante :
une bretelle séparable (22) destinée à la fixation optionnelle de la suspension élastique (14) en un point de fixation, pour limiter, à l'état non séparable, une zone de déformation de la suspension élastique (14) dans laquelle se déforme élastiquement la suspension élastique (14) lors d'une oscillation du corps oscillant et l'agrandir à l'état séparé.

5. Composant micromécanique selon la revendication 4, présentant plusieurs bretelles séparables destinées à la fixation de la suspension élastique (14) en un point de fixation (14) respectif à l'état non séparé.

6. Composant micromécanique selon la revendication 4 ou 5, dans lequel la suspension élastique (14) présente une première partie (14a1) de petite section et une deuxième partie (14a2) de grande section.

7. Composant micromécanique selon la revendication 6, dans lequel sont par ailleurs formés, dans le plan (16), un cadre (20) avec une ancre (20k, 201) à laquelle est fixée la suspension élastique (14) et une bretelle (22) qui s'étend entre un point de fixation de la suspension élastique (14) et le cadre (20), et qui est soit séparée, soit non séparée.

8. Composant micromécanique selon la revendication 6 ou 7, dans lequel le corps oscillant et l'électrode stationnaire sont formés dans une couche qui s'étend dans le plan et l'électrode statique (20a, 20b; 60a, 60b) se trouve au-dessus d'un interstice dans la couche (16) au droit de la partie du pourtour du corps oscillant (12) qui, lors d'une oscillation du système oscillant, subit la déviation la plus grande.

9. Composant micromécanique selon l'une des revendications 1 à 7, avec une première autre électrode stationnaire (40a) qui est disposée de sorte que, lors d'une déviation du corps oscillant (12) dans une première direction de déviation à partir de sa position de repos, elle se rapproche de l'au moins une partie du corps oscillant (12) et que, lors d'une déviation du corps oscillant (12) dans une deuxième direction de déviation à partir de sa position de repos, elle s'éloigne de l'au moins une partie du corps oscillant (12), et avec une deuxième autre électrode stationnaire (40b) qui est disposée de sorte que, lors d'une déviation du corps oscillant (12) dans la première direction de déviation à partir de sa position de repos, elle s'éloigne de l'au moins une partie du corps oscillant (12) et que, lors d'une déviation du corps oscillant (12) dans la deuxième direction de déviation à partir de sa position de repos, elle se rapproche de l'au moins une partie du corps oscillant (12).

10. Composant micromécanique selon l'une des revendications 1 à 9, dans lequel sont formés, dans une couche (16) s'étendant dans le plan, un premier ressort de torsion (14a), un deuxième ressort de torsion (14a) et le corps oscillant (12), le premier et le deuxième ressort de torsion (14a, 14b) définissant un axe de pivotement pour le corps oscillant (12) qui divise le corps oscillant en une première et une deuxième partie qui, lors d'une déviation du corps oscillant (12) hors d'une position de repos, se déplacent dans différentes directions hors du plan, une première et la deuxième électrode statique (40a, 40b) étant disposées soit au-dessous, soit au-dessus du corps oscillant (12) et la première autre électrode statique (40a) étant située au droit de l'une des deux parties et la deuxième autre électrode statique (40b) étant située au droit de l'autre des deux parties du corps oscillant (12).

11. Composant micromécanique selon l'une des revendications 1 à 10, dans lequel la suspension élastique (14) agit comme ressort de torsion.

12. Composant micromécanique selon l'une des revendications 1 à 11, dans lequel la suspension élastique (14) agit comme ressort de flexion tendu d'un côté.

13. Composant micromécanique selon l'une des revendications 1 à 11, dans lequel la suspension élastique (14) est disposée de manière à limiter un mouvement d'oscillation du corps oscillant (12) à un mouvement de culbutement autour d'un axe de pivotement.

14. Composant micromécanique selon l'une des revendications 1 à 11, dans lequel la suspension élastique (14) est disposée de manière à limiter un mouvement d'oscillation du corps oscillant (12) à un mouvement de translation le long d'un axe d'oscillation.

15. Procédé permettant de faire fonctionner un composant micromécanique avec un système d'oscillation qui présente un corps oscillant et une suspension élastique formés tous deux dans un plan, le corps oscillant étant suspendu de manière apte à osciller par la suspension élastique (14) de sorte qu'une partie du corps oscillant (12) se déplace hors du plan; le procédé comprenant l'étape suivante consistant à:
régler une fréquence de résonance du système oscillant par application d'une différence de tension constante entre au moins une partie du corps oscillant et au moins une électrode stationnaire qui est également formée dans le plan.
